(19) **Europäisches Patentamt European Patent Office Office européen des brevets**

(11) **EP 4 191 854 B1**

(12) **FASCICULE DE BREVET EUROPEEN**

(45) Date de publication et mention de la délivrance du brevet:
**24.09.2025 Bulletin 2025/39**

(21) Numéro de dépôt: **22211180.9**

(22) Date de dépôt: **02.12.2022**

(51) Classification Internationale des Brevets (IPC):
*H02M 1/088* (2006.01)  *H02M 3/00* (2006.01)
*H02M 1/00* (2006.01)  *H02M 3/335* (2006.01)

(52) Classification Coopérative des Brevets (CPC):
**H02M 1/0058; H02M 3/01; H02M 3/33573; H02M 3/33576;** Y02B 70/10

(54) **DISPOSITIF ÉLECTRONIQUE ET PROCÉDÉ DE PILOTAGE SANS MODE COMMUN D'UN CONVERTISSEUR D ÉNERGIE ÉLECTRIQUE COMPORTANT DEUX ÉLÉMENTS PIÉZOÉLECTRIQUES, SYSTÈME ÉLECTRONIQUE DE CONVERSION D ÉNERGIE ÉLECTRIQUE ASSOCIÉ**

ELEKTRONISCHE VORRICHTUNG UND VERFAHREN ZUR GLEICHTAKTFREIEN STEUERUNG EINES ELEKTRISCHEN ENERGIEWANDLERS MIT ZWEI PIEZOELEKTRISCHEN ELEMENTEN, ELEKTRONISCHES STROMWANDLERSYSTEM DAFÜR

ELECTRONIC DEVICE AND METHOD FOR COMMON-MODE-FREE CONTROL OF AN ELECTRIC POWER CONVERTER COMPRISING TWO PIEZOELECTRIC ELEMENTS, ASSOCIATED ELECTRONIC POWER CONVERSION SYSTEM

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **03.12.2021 FR 2112925**

(43) Date de publication de la demande:
**07.06.2023 Bulletin 2023/23**

(73) Titulaire: **Commissariat à l'Energie Atomique et aux Energies Alternatives 75015 Paris (FR)**

(72) Inventeurs:
• **DESPESSE, Ghislain 38054 GRENOBLE CEDEX 9 (FR)**
• **TOUHAMI, Mustapha 38054 GRENOBLE CEDEX 9 (FR)**
• **BRETON, Valentin 38054 GRENOBLE CEDEX 9 (FR)**

(74) Mandataire: **Lavoix 2, place d'Estienne d'Orves 75441 Paris Cedex 09 (FR)**

(56) Documents cités:
CN-A- 102 522 492     US-A1- 2013 169 198
US-A1- 2017 012 556

• **POLLET BENJAMIN: "Convertisseurs DC-DC piézoélectrique avec stockage provisoire d'énergie sous forme mécanique", 15 November 2019 (2019-11-15), pages 1 - 169, XP055862319, Retrieved from the Internet <URL:https://tel. archives-ouvertes.fr/tel-02415837/document> [retrieved on 20211116]**

**Description**

La présente invention concerne un dispositif électronique de pilotage d'un convertisseur d'énergie électrique apte à convertir une tension d'entrée en au moins une tension de sortie.

Le convertisseur comporte un premier pont de commutation comportant deux premières branches de commutation, chaque première branche de commutation étant connectée entre deux bornes d'application de la tension d'entrée et comportant au moins deux premiers interrupteurs connectés en série et reliés entre eux en un premier point milieu ; au moins un deuxième pont de commutation comportant deux deuxièmes branches de commutation, chaque deuxième branche de commutation étant connectée entre deux bornes de fourniture de la tension de sortie et comportant au moins deux deuxièmes interrupteurs connectés en série et reliés entre eux en un deuxième point milieu ; et au moins un couple de premier et deuxième ensembles piézoélectriques, chaque ensemble piézoélectrique comportant au moins un élément piézoélectrique et étant connecté entre des premier et deuxième points milieux respectifs, les points milieux entre lesquels sont connectés les ensembles piézoélectriques étant distincts d'un ensemble piézoélectrique à l'autre.

Le dispositif électronique de pilotage est configuré pour commander, lors d'un cycle respectif de résonance des ensembles piézoélectriques, une commutation de chacun des interrupteurs pour alterner des phases à tension sensiblement constante aux bornes des ensembles piézoélectriques et des phases à charge sensiblement constante aux bornes desdits ensembles piézoélectriques.

L'invention concerne également un système électronique de conversion d'énergie électrique comprenant un tel convertisseur d'énergie électrique et un dispositif électronique de pilotage dudit convertisseur.

L'invention concerne aussi un procédé de pilotage d'un tel convertisseur d'énergie électrique, le procédé étant mis en œuvre par un tel dispositif électronique de pilotage.

L'invention concerne le domaine des systèmes électroniques de conversion d'énergie électrique, en particulier ceux comportant un élément piézoélectrique, notamment des systèmes de conversion en une énergie électrique continue, c'est-à-dire les systèmes de conversion continu-continu, également appelés systèmes de conversion DC-DC (de l'anglais *Direct Current - Direct Current*), et les systèmes de conversion alternatif-continu, également appelés systèmes de conversion AC-DC (de l'anglais *Alternating Current - Direct Current).*

On connait des documents FR 3 086 471 A1 et FR 3 086 472 A1, ainsi que du manuscrit de thèse *« Convertisseurs DC-DC piézoélectrique avec stockage provisoire d'énergie sous forme mécanique »* de Benjamin POLLET, un convertisseur d'énergie électrique du type précité, visible sur la figure 20 des documents FR 3 086 471 A1 et FR 3 086 472 A1, et sur la figure 4.15 du manuscrit de thèse précité.

US 2013/169198 A1 décrit un circuit de commande piézoélectrique à commutation de tension nulle comprenant un circuit de commande en demi-pont, un élément piézoélectrique, et au moins un circuit de dérivation.

Comme indiqué dans le document FR 3 086 471 A1 ou encore dans le manuscrit de thèse, un avantage qu'il y a à utiliser deux éléments piézoélectriques est que la tension de sortie est ainsi isolée de la tension d'entrée, sans pour autant qu'il soit nécessaire d'utiliser un transformateur.

L'isolation est capacitive et ne se fait donc pas avec un transformateur qui est source de pertes, mais par le fait que l'impédance du résonateur piézoélectrique est très élevée en basse fréquence et bloque toute propagation de la tension à basse fréquence de l'entrée vers la sortie, et inversement. En outre, la composante de mode commun d'entrée égale à la moitié de la somme des potentiels en les bornes d'application de la tension d'entrée ne se répercute pas sur la composante de mode commun de sortie égale à la moitié de la somme des potentiels en les bornes de fourniture de la tension de sortie et inversement. Les potentiels ou composantes de modes commun d'entrée et de sortie peuvent ainsi évoluer librement, en basse fréquence, l'un par rapport à l'autre. En effet, chaque élément piézoélectrique est modélisé sous forme d'un condensateur et d'une branche résonante connectée en parallèle du condensateur, la capacité dudit condensateur étant appelée capacité parallèle, ou encore capacité de référence, et notée $C_0$. Un signal basse fréquence de type 50/60 Hz sera alors filtré par la haute impédance (par exemple 3,1 MΩ pour $C_0$ = 1 nF à 50 Hz) de chacune des capacités bloquées des deux résonateurs piézoélectriques créant ainsi une isolation entre les parties entrées et sortie du convertisseur.

Cet avantage est présent même par rapport à un transformateur piézoélectrique, dans lequel toute l'énergie apportée au primaire n'est pas complètement transmise au secondaire et le primaire doit par ailleurs mettre en mouvement une masse plus grande, à savoir celle du primaire plus celle du secondaire, ce qui engendre des pertes.

Toutefois, le fonctionnement d'un tel convertisseur n'est pas optimal autour de la fréquence de résonance des éléments piézoélectriques.

Le but de l'invention est alors de proposer un dispositif électronique, et un procédé associé, de pilotage d'un tel convertisseur d'énergie électrique offrant un pilotage amélioré du convertisseur, notamment une meilleure isolation.

A cet effet, l'invention a pour objet un dispositif électronique de pilotage d'un convertisseur d'énergie électrique, selon la revendication 1.

Avec le convertisseur et le dispositif de pilotage associé de l'état de la technique, si la composante continue ou basse fréquence, typiquement inférieure à 1 kHz, est naturellement filtrée par le comportement capacitif des piézoélectriques à basse fréquence comme décrit précédemment, les composantes autour de la fréquence de résonance du piézoélectrique passent naturellement de l'entrée vers la sortie et inversement.

Avec le dispositif de pilotage selon l'invention, le cycle de conversion est adapté pour que ce dernier permette bien de transférer de la puissance de l'entrée vers la sortie, mais sans injecter de composante de mode commun.

Durant les phases à tension sensiblement constante aux bornes des ensembles piézoélectriques, la tension aux bornes des ensembles piézoélectriques ne varie pas et ne peut pas induire une tension de mode commun haute fréquence.

Durant les phases à charge sensiblement constante aux bornes desdits ensembles piézoélectriques, la position fermée d'au plus un interrupteur respectif parmi les interrupteurs connectés directement au premier ensemble piézoélectrique et d'au plus un interrupteur respectif parmi les interrupteurs connectés directement au deuxième ensemble piézoélectrique en même temps, tous les autres interrupteurs des premières et deuxièmes branches de commutation étant en position ouverte, permet d'éviter la connexion de l'un ou l'autre des ensembles piézoélectriques entre un potentiel de la tension d'entrée et un potentiel de la tension de sortie, et alors d'éviter l'introduction d'une composante de mode commun haute fréquence entre la tension d'entrée et la tension de sortie.

Suivant d'autres aspects avantageux de l'invention, le dispositif électronique de pilotage est selon l'une quelconque des revendications 2 à 4.

L'invention a aussi pour objet un système électronique de conversion d'énergie électrique, selon la revendication 5.

Suivant d'autres aspects avantageux de l'invention, le système électronique de conversion d'énergie électrique est selon l'une quelconque des revendications 6 à 11.

L'invention a également pour objet un procédé de pilotage d'un convertisseur d'énergie électrique, selon la revendication 12.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

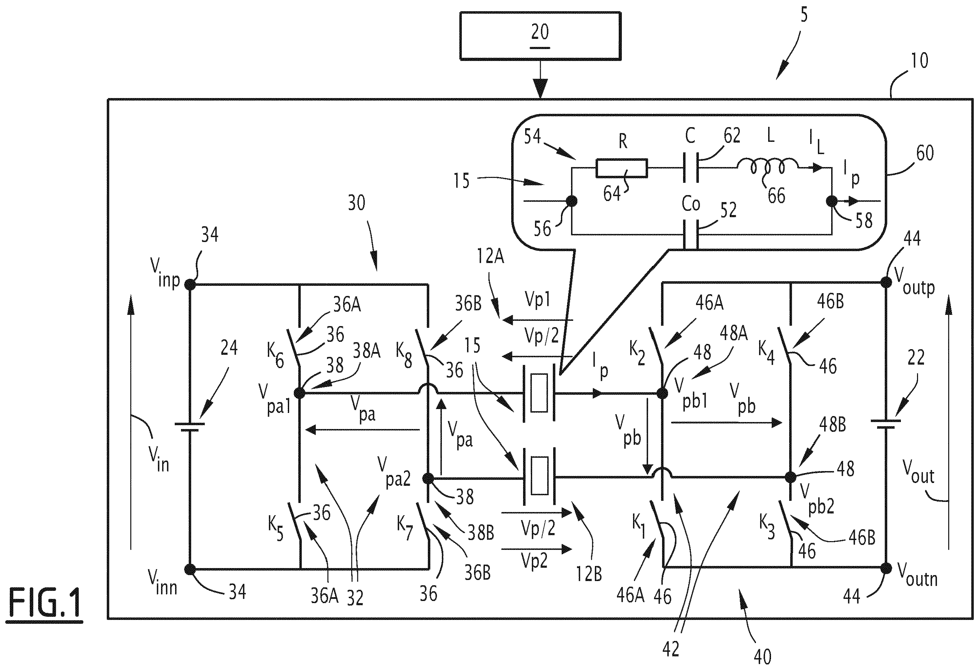

- la figure 1 est une représentation schématique d'un système électronique de conversion d'énergie électrique selon l'invention, comprenant un convertisseur d'énergie électrique et un dispositif électronique de pilotage dudit convertisseur, le convertisseur comportant un premier pont de commutation avec deux premières branches de commutation formées chacune de deux premiers interrupteurs connectés en série et reliés en un premier point milieu, un deuxième pont de commutation avec deux deuxièmes branches de commutation formées chacune de deux deuxièmes interrupteurs connectés en série et reliés en un deuxième point milieu, un couple de premier et deuxième ensembles piézoélectriques, chaque ensemble piézoélectrique comportant un élément piézoélectrique et étant connecté entre des premier et deuxième points milieux respectifs, les points milieux entre lesquels sont connectés les ensembles piézoélectriques étant distincts d'un ensemble piézoélectrique à l'autre ; les premier, et respectivement deuxième, ponts étant connectés entre deux bornes d'application d'une tension d'entrée, et respectivement entre deux bornes de fourniture d'une tension de sortie ;

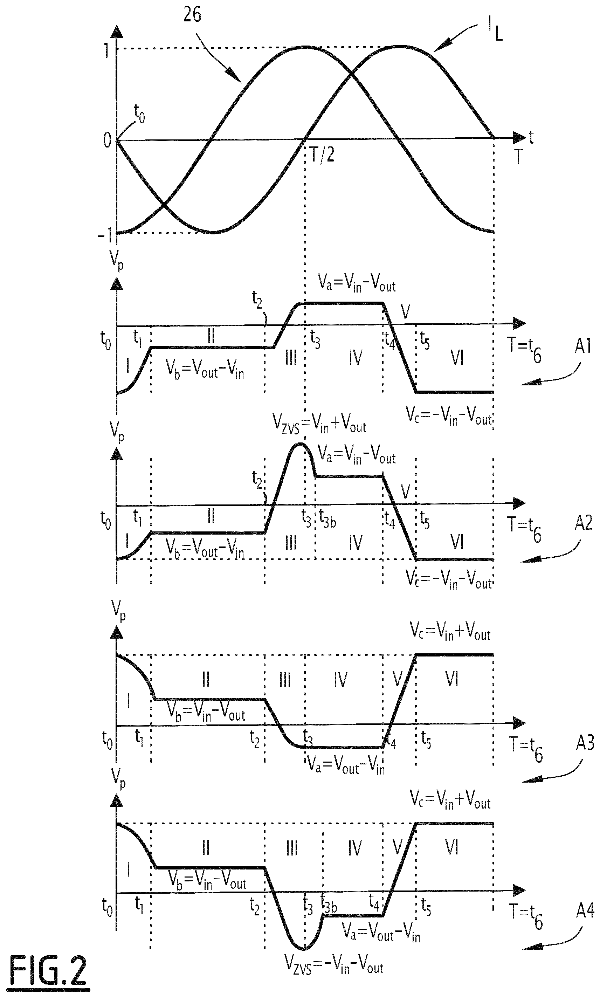

- la figure 2 est un ensemble de courbes représentant un courant circulant dans les ensembles piézoélectriques normalisée à une amplitude de 1, une déformation mécanique totale des ensembles piézoélectriques normalisée à une amplitude de 1, une tension entre des extrémités dudit couple d'ensembles piézoélectriques, une tension entre les autres extrémités dudit couple d'ensembles piézoélectriques, ainsi qu'une tension totale des ensembles piézoélectriques correspondant à la somme desdites tensions élémentaires aux bornes de chaque ensemble piézoélectrique, et ce pour différentes configurations de conversions d'énergie électrique, à savoir pour quatre configurations abaisseur de tension ;
- la figure 3 est une vue analogue à celle de la figure 2, pour d'autres configurations de conversions d'énergie électrique, à savoir pour quatre configurations élévateur de tension ;
- la figure 4 est une vue analogue à celle de la figure 1, selon un autre exemple du convertisseur d'énergie électrique, où le convertisseur d'énergie électrique est apte à convertir la tension d'entrée en plusieurs tensions de sortie distinctes, et comporte - pour chaque tension de sortie respective - un deuxième pont de commutation respectif, chaque deuxième branche de commutation étant connectée entre deux bornes de fourniture de ladite tension de sortie respective, et un couple respectif de premier et deuxième ensembles piézoélectriques ;
- la figure 5 est une vue analogue à celle de la figure 1, selon un aspect complémentaire où le convertisseur comprend en outre un circuit d'aide à la commutation connecté entre les premier et deuxième points milieux du deuxième pont ;
- la figure 6 est une représentation schématique de différents types de circuit d'aide à la commutation ;
- la figure 7 est une vue analogue à celle de la figure 2, selon l'aspect complémentaire de la figure 5, l'ensemble de courbes représentant en outre la somme des tensions élémentaires aux bornes de chaque ensemble piézoélectrique, et ce pour deux configurations abaisseur de tension ;
- la figure 8 est une vue analogue à celle de la figure 5, selon une variante de réalisation de l'aspect complémentaire, où le circuit d'aide à la commutation est connecté entre les premier et deuxième points milieux du premier pont ; et

- la figure 9 est une vue analogue à celle de la figure 7, pour d'autres configurations de conversions d'énergie électrique, à savoir pour deux configurations élévateur de tension, typiquement selon la variante de réalisation de l'aspect complémentaire.

L'expression « sensiblement égal(e) à » définit une relation d'égalité à plus ou moins 10%, de préférence à plus ou moins 5%.

Sur la figure 1, un système électronique de conversion d'énergie électrique 5 comprend un convertisseur d'énergie électrique 10 comportant un couple de premier 12A et deuxième 12B ensembles piézoélectriques, chaque ensemble piézoélectrique 12A,12B comportant au moins un élément piézoélectrique 15, le convertisseur 10 comportant plusieurs interrupteurs $K_1$, $K_2$, $K_3$, $K_4$, $K_5$, $K_6$, $K_7$, $K_8$ aptes à être commandés pour alterner des phases II, IV, VI à tension sensiblement constante aux bornes des ensembles piézoélectriques 12A, 12B et des phases I, III, V à charge sensiblement constante aux bornes des ensembles piézoélectriques 12A, 12B.

Le système électronique de conversion d'énergie électrique 5 comprend aussi un dispositif électronique 20 de pilotage du convertisseur d'énergie électrique 10.

Le système électronique de conversion d'énergie électrique 5 est typiquement un système de conversion en une énergie électrique continue, tel qu'un système de conversion continu-continu apte à convertir une première énergie ou tension électrique continue reçue en entrée en une deuxième énergie ou tension électrique continue délivrée en sortie, ou encore un système de conversion alternatif-continu apte à convertir une énergie ou tension électrique alternative reçue en entrée en une énergie ou tension électrique continue délivrée en sortie du système de conversion 5.

Lorsque le système de conversion d'énergie électrique 5 est un système de conversion alternatif-continu, le système de conversion d'énergie électrique 5 comprend de préférence en outre un redresseur de tension, non représenté, connecté en entrée du convertisseur d'énergie électrique 10 et apte à redresser la tension électrique alternative reçue en entrée du système de conversion 5 pour délivrer une tension électrique redressée en entrée du convertisseur 10, le convertisseur d'énergie électrique 10 étant de préférence un convertisseur continu-continu apte à convertir une énergie ou tension électrique continue en une autre énergie ou tension électrique continue. Le redresseur de tension est par exemple un pont redresseur, tel qu'un pont de diodes. En variante, le redresseur de tension est formé en partie par des interrupteurs du convertisseur 10.

L'homme du métier observera que ces différents exemples pour le système conversion 5, qu'il s'agisse d'un système de conversion continu-continu ou bien d'un système de conversion alternatif-continu, sont également présentés dans les documents FR 3 086 471 A1 et FR 3 086 472 A1, notamment en regard de leurs figures 1 et 2.

Le convertisseur d'énergie électrique 10 est de préférence un convertisseur continu-continu, et est également appelé convertisseur DC-DC. Le convertisseur continu-continu a généralement pour rôle de réguler une tension d'alimentation d'une charge 22 à une valeur stable, en étant alimenté par une source d'énergie 24 fournissant une tension sensiblement continue. La source d'énergie 24 est par exemple une batterie ou un panneau solaire.

Le convertisseur d'énergie électrique 10 est alors configuré pour élever la valeur de la tension continue entre son entrée et sa sortie, et est alors également appelé convertisseur continu-continu élévateur ; ou bien est configuré pour abaisser la valeur de la tension continue entre son entrée et sa sortie, et est alors appelé convertisseur continu-continu abaisseur.

Le convertisseur d'énergie électrique 10 est configuré pour délivrer N tension(s) de sortie distincte(s), à partir de E tension(s) d'entrée distincte(s), E et N étant chacun un nombre entier supérieur ou égal à 1.

Dans l'exemple de la figure 1, le convertisseur d'énergie électrique 10 est configuré pour délivrer une tension de sortie, notée $V_{out}$, à partir d'une tension d'entrée, notée $V_{in}$, le nombre E de tension(s) d'entrée et le nombre N de tension(s) de sortie étant alors chacun égal à 1.

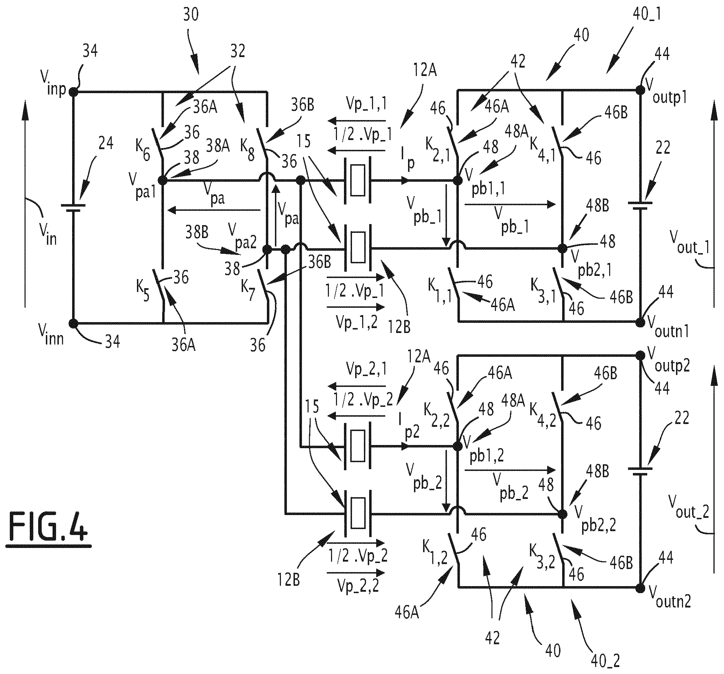

Dans l'exemple de la figure 4, le convertisseur d'énergie électrique 10 est configuré pour délivrer plusieurs tensions de sortie distinctes, notées $V_{out\_j}$ où j est un indice entier compris entre 1 et N, à partir de la tension d'entrée $V_{in}$, le nombre N de tensions de sortie distinctes étant alors supérieur à 1. Selon cet exemple, le convertisseur 10 est typiquement connecté à plusieurs charges 22, comme représenté sur la figure 4.

Le convertisseur d'énergie électrique 10 comporte les ensembles piézoélectriques 12A, 12B formés chacun d'un ou plusieurs éléments piézoélectriques 15, et le dispositif de pilotage 20 est configuré pour faire fonctionner le matériau piézoélectrique des éléments piézoélectriques 15 à leur résonance afin d'exploiter des phases de transfert de charge permettant de s'affranchir de l'utilisation d'un élément inductif, tout en régulant la tension de sortie en conservant la résonance du matériau piézoélectrique, c'est-à-dire avec des cycles de commutation répétés à une fréquence de fonctionnement dépendant de la fréquence de résonance des éléments piézoélectriques 15, et en ajustant les durées de phases de commutation respectives à l'intérieur du cycle de résonance.

En régime établi, les ensembles piézoélectriques 12A, 12B échangent une charge et une puissance sensiblement nulle sur un cycle de résonance, aux pertes près. Autrement dit, chaque ensemble piézoélectrique 12A, 12B redonne, sensiblement autant qu'il reçoit, d'énergie et de charge sur une période. Deux conditions de fonctionnement s'appliquent alors au régime permanent/établi, à savoir l'équilibre de charge et l'équilibre d'énergie sur une période de résonance. Même si durant les transitoires (démarrage, variation des paliers de tension, changement du courant de sortie) cette équilibre n'est pas respecté, il faut néanmoins qu'il puisse être atteint en régime établi. Ceci impose notamment un certain agencement des paliers de tension durant la période de résonance. Par exemple, pour un fonctionnement à trois paliers de tension, les deux paliers de tension extrêmes sont commandés lors d'une demi-période d'une polarité donnée d'un courant $I_L$ circulant dans les éléments piézoélectriques 15, et le palier de tension intermédiaire est commandé lors de l'autre demi-période de polarité opposée du courant $I_L$ circulant dans les éléments piézoélectriques 15.

Comme connu en soi, l'oscillation mécanique des éléments piézoélectriques 15 est approximativement sinusoïdale, ainsi que représenté sur les figures 2, 3, 7 et 9 par la courbe 26 illustrant la déformation mécanique totale des éléments piézoélectriques 15 au cours d'un cycle de résonance respectif. La déformation mécanique totale des éléments piézoélectriques 15 est la somme de déformations mécaniques élémentaires de chacun des éléments piézoélectriques 15.

Une augmentation ou une diminution de l'énergie stockée sur une période conduit respectivement à une augmentation ou à une diminution de l'amplitude d'oscillation. Par ailleurs, lors d'une phase à charge sensiblement constante aux bornes des ensembles piézoélectriques 12A, 12B, c'est-à-dire lorsque les éléments piézoélectriques 15 sont placés dans un circuit électrique sensiblement ouvert, avec un faible échange de charges électriques entre les éléments piézoélectriques 15 et l'extérieur, une augmentation de l'amplitude des oscillations engendre une augmentation de la vitesse de variation de la tension $V_p$ aux bornes des ensembles piézoélectriques 12A, 12B, et lors d'une phase II, IV, VI à tension sensiblement constante aux bornes des ensembles piézoélectriques 12A, 12B, cette augmentation d'amplitude d'oscillation conduit à une augmentation d'un courant $I_p$ échangé entre les éléments piézoélectriques 15 et les paliers de tension.

Par charge sensiblement constante, on entend un échange d'une charge avec l'extérieur qui est inférieur à 10% de la charge qui aurait été échangée avec l'extérieur si la tension avait été maintenue constante. Autrement dit, par charge sensiblement constante, on entend une variation de charge inférieure à 10% de la charge qui aurait été échangée avec l'extérieur des ensembles piézoélectriques 12A, 12B si la tension aux bornes des ensembles piézoélectriques 12A, 12B avait été maintenue constante sur la durée temporelle considérée.

Par circuit électrique sensiblement ouvert, on entend un circuit dont un éventuel courant de fuite conduit à une variation de charge des ensembles piézoélectriques 12A, 12B inférieure à 10% de la charge qui aurait été échangée avec l'extérieur des ensembles piézoélectriques 12A, 12B si la tension aux bornes des ensembles piézoélectriques 12A, 12B avait été maintenue constante sur la durée temporelle considérée.

Par tension sensiblement constante, on entend une variation de tension inférieure à 20%, de préférence inférieure à 10%, de la tension d'entrée ou de sortie du convertisseur 10. À titre d'exemple, si la tension d'entrée du convertisseur 10 est égale à 100V, alors la variation de tension lors de chaque phase II, IV, VI à tension sensiblement constante, c'est-à-dire sur chaque palier à tension sensiblement constante, est inférieure à 20% de cette tension, c'est-à-dire inférieure à 20V ; de préférence inférieure à 10 % de cette tension, c'est-à-dire inférieure à 10V. Chaque phase à tension sensiblement constante est également appelée palier de tension.

Le convertisseur 10 comporte alors plusieurs interrupteurs $K_1$, $K_2$, $K_3$, $K_4$, $K_5$, $K_6$, $K_7$, $K_8$ visibles sur les figures 1, 5 et 8, $K_{1,1}$, $K_{2,1}$, $K_{3,1}$, $K_{4,1}$, $K_{1,2}$, $K_{2,2}$, $K_{3,2}$, $K_{4,2}$, $K_5$, $K_6$, $K_7$, $K_8$ visibles sur la figure 4, aptes à être commandés pour alterner des phases II, IV, VI à tension sensiblement constante et des phases I, III, V à charge sensiblement constante aux bornes des ensembles piézoélectriques 12A, 12B, à l'intérieur de périodes de durée sensiblement constante correspondant à la fréquence de fonctionnement du convertisseur 10, dépendant de la fréquence de résonance, également appelée fréquence propre, des éléments piézoélectriques 15. Les phases I, III, V à charge sensiblement constante permettent, en régime établi ou permanent, de passer d'une tension constante à une autre et de fermer les interrupteurs qui doivent l'être lorsque la tension à leurs bornes est de préférence nulle afin d'avoir une commutation dite à zéro de tension, également appelée commutation en mode ZVS (de l'anglais *Zero Voltage Switching*).

En particulier, le convertisseur 10 comprend un premier pont de commutation 30 comportant deux premières branches de commutation 32, chaque première branche de commutation 32 étant connectée entre deux bornes 34 d'application de la tension d'entrée $V_{in}$ et comportant au moins deux premiers interrupteurs 36 connectés en série et reliés entre eux en un premier point milieu 38. Parmi les deux bornes d'application 34, l'une présente un potentiel inférieur, noté $V_{inn}$, à l'autre, noté $V_{inp}$. Le premier pont de commutation 30 est de préférence constitué des deux premières branches de commutation 32.

Dans les exemples des figures 1, 4, 5 et 8, chaque première branche de commutation 32 comporte deux premiers interrupteurs 36 connectés en série et reliés en le premier point milieu 38. Chaque première branche de commutation 32 est de préférence constituée des deux premiers interrupteurs 36.

Dans ces exemples, les deux premiers interrupteurs 36 sont notés $K_5$, $K_6$ pour l'une des deux premières branches de commutation 32, et respectivement $K_7$, $K_8$ pour l'autre des deux premières branches de commutation 32.

Par souci de distinction entre les premiers interrupteurs 36 connectés directement au premier ensemble piézoélectrique 12A et ceux connectés directement au deuxième ensemble piézoélectrique 12B, les premiers interrupteurs 36 connectés directement au premier ensemble piézoélectrique 12A sont également notés 36A, et les premiers interrupteurs 36 connectés directement au deuxième ensemble piézoélectrique 12B sont également notés 36B.

Dans les exemples des figures 1, 4, 5 et 8, les premiers interrupteurs 36A connectés directement au premier ensemble piézoélectrique 12A sont aussi notés $K_5$, $K_6$, et les premiers interrupteurs 36B connectés directement au deuxième ensemble piézoélectrique 12B sont aussi notés $K_7$, $K_8$.

De même, le premier point milieu 38 connecté directement au premier ensemble piézoélectrique 12A est également noté 38A, et le premier point milieu 38 connecté directement au deuxième ensemble piézoélectrique 12B est également noté 38B.

Le convertisseur 10 comprend un deuxième pont de commutation 40 comportant deux deuxièmes branches de commutation 42, chaque deuxième branche de commutation 42 étant connectée entre deux bornes 44 de fourniture de la tension de sortie $V_{out}$ et comportant au moins deux deuxièmes interrupteurs 46 connectés en série et reliés entre eux en un deuxième point milieu 48. Parmi les deux bornes de fourniture 44, l'une présente un potentiel inférieur, noté $V_{outn}$, à l'autre, noté $V_{outp}$. Le deuxième pont de commutation 40 est de préférence constitué des deux deuxièmes branches de commutation 42.

Dans les exemples des figures 1, 4, 5 et 8, chaque deuxième branche de commutation 42 comporte deux deuxièmes interrupteurs 46 connectés en série et reliés en le deuxième point milieu 48. Chaque deuxième branche de commutation 42 est de préférence constituée des deux deuxièmes interrupteurs 46.

Dans les exemples des figures 1, 5 et 8, les deux deuxièmes interrupteurs 46 sont notés $K_1$, $K_2$ pour l'une des deux deuxièmes branches de commutation 42, et respectivement $K_3$, $K_4$ pour l'autre des deux deuxièmes branches de commutation 42.

Lorsque le convertisseur d'énergie électrique 10 est configuré pour délivrer plusieurs tensions de sortie distinctes $V_{out\_j}$, il comprend, pour chaque tension de sortie $V_{out\_j}$ respective, un deuxième pont de commutation 40 respectif, chaque deuxième branche de commutation 42 étant connectée entre deux bornes 44 de fourniture de la tension de sortie $V_{out\_j}$ respective.

Dans l'exemple de la figure 4, le convertisseur d'énergie électrique 10 est configuré pour délivrer deux tensions de sortie distinctes, à savoir une première tension de sortie $V_{out\_1}$ et une deuxième tension de sortie $V_{out\_2}$. Selon cet exemple, le convertisseur 10 comprend alors deux deuxièmes ponts de commutation 40, celui associé à la première tension de sortie $V_{out\_1}$ étant noté 40_1 et celui associé à la deuxième tension de sortie $V_{out\_2}$ étant noté 40_2. Chaque deuxième branche de commutation 42 étant connectée entre deux bornes 44 de fourniture de la tension de sortie $V_{out\_1}$, $V_{out\_2}$ respective. Dans cet exemple, les potentiels inférieurs des tensions de sortie $V_{out\_1}$, $V_{out\_2}$ sont respectivement notés $V_{outn1}$, $V_{outn2}$, et les potentiels supérieurs des tensions de sortie $V_{out\_1}$, $V_{out\_2}$ sont respectivement notés $V_{outp1}$, $V_{outp2}$. Dans cet exemple encore, les deuxièmes interrupteurs 46 sont notés $K_{1,1}$, $K_{2,1}$, $K_{3,1}$, $K_{4,1}$ pour le deuxième pont de commutation 40_1 associé à la première tension de sortie $V_{out\_1}$, et les deuxièmes interrupteurs 46 sont notés $K_{1,2}$, $K_{2,2}$, $K_{3,2}$, $K_{4,2}$ pour le deuxième pont de commutation 40_2 associé à la deuxième tension de sortie $V_{out\_2}$.

Par souci de distinction entre les deuxièmes interrupteurs 46 connectés directement au premier ensemble piézoélectrique 12A et ceux connectés directement au deuxième ensemble piézoélectrique 12B, les deuxièmes interrupteurs 46 connectés directement au premier ensemble piézoélectrique 12A sont également notés 46A, et les deuxièmes interrupteurs 46 connectés directement au deuxième ensemble piézoélectrique 12B sont également notés 46B.

Dans les exemples des figures 1, 5 et 8, les deuxièmes interrupteurs 46A connectés directement au premier ensemble piézoélectrique 12A sont aussi notés $K_1$, $K_2$, et les deuxièmes interrupteurs 46B connectés directement au deuxième ensemble piézoélectrique 12B sont aussi notés $K_3$, $K_4$.

Dans l'exemple de la figure 4, les deuxièmes interrupteurs 46A connectés directement au premier ensemble piézoélectrique 12A sont aussi notés $K_{1,1}$, $K_{2,1}$, pour le deuxième pont de commutation 40_1 associé à la première tension de sortie $V_{out\_1}$, et $K_{1,2}$, $K_{2,2}$, pour le deuxième pont de commutation 40_2 associé à la deuxième tension de sortie $V_{out\_2}$. Dans cet exemple, les deuxièmes interrupteurs 46B connectés directement au deuxième ensemble piézoélectrique 12B sont aussi notés $K_{3,1}$, $K_{4,1}$ pour le deuxième pont de commutation 40_1 associé à la première tension de sortie $V_{out\_1}$, et $K_{3,2}$, $K_{4,2}$ pour le deuxième pont de commutation 40_2 associé à la deuxième tension de sortie $V_{out\_2}$.

De même, le deuxième point milieu 48 connecté directement au premier ensemble piézoélectrique 12A est également noté 48A, et le deuxième point milieu 48 connecté directement au deuxième ensemble piézoélectrique 12B est également noté 48B.

Le convertisseur 10 comprend un ou plusieurs couples de premier 12A et deuxième 12B ensembles piézoélectriques, chaque ensemble piézoélectrique 12A, 12B comportant au moins un élément piézoélectrique 15 et étant connecté entre des premier 38 et deuxième 48 points milieux respectifs, les points milieux 38, 48 entre lesquels sont connectés les ensembles piézoélectriques 12A, 12B étant distincts d'un ensemble piézoélectrique 12A à l'autre 12B.

Dans les exemples des figures 1, 5 et 8, le convertisseur 10 comprend un seul couple de premier 12A et deuxième 12B ensembles piézoélectriques.

Lorsque le convertisseur d'énergie électrique 10 est configuré pour délivrer plusieurs tensions de sortie distinctes $V_{out\_j}$, il comprend, pour chaque tension de sortie $V_{out\_j}$ respective, un couple respectif de premier 12A et deuxième 12B ensembles piézoélectriques.

Dans l'exemple de la figure 4, le convertisseur d'énergie électrique 10 est configuré pour délivrer deux tensions de sortie distinctes, et comprend alors deux couples de premier 12A et deuxième 12B ensembles piézoélectriques.

Chaque interrupteur du convertisseur 10, à savoir chacun des premiers 36 et deuxièmes 46 interrupteurs, est de préférence un interrupteur unidirectionnel en courant et unidirectionnel en tension. L'interrupteur 36, 46 comprend par exemple un transistor, ou une diode, ou encore un transistor et une diode en antiparallèle, non représentés. L'interrupteur 36, 46 est de préférence constitué du transistor, ou de la diode, ou encore du transistor et de la diode en antiparallèle. En variante, l'interrupteur 36, 46 comprend une association de plusieurs transistors, et est de préférence constitué d'une telle association de plusieurs transistors. En variante encore, l'interrupteur 36, 46 comprend un switch mécanique, tel qu'un micro-switch MEMS (de l'anglais *MicroElectroMechanical System*).

Le transistor est, par exemple, un transistor à effet de champ à grille isolée, également appelé MOSFET (de l'anglais *Metal Oxide Semiconductor Field Effect Transistor*). En variante, le transistor est un transistor bipolaire ; un transistor bipolaire à grille isolée, également appelé IGBT (de l'anglais *Insulated Gate Bipolar Transistor)* ; un transistor à base de silicium (Si), un transistor à base de GaN (de l'anglais *Gallium Nitride)* ; un transistor à base de carbure de silicium (SiC), ou un transistor à base de diamant, ou encore un thyristor.

Chaque ensemble piézoélectrique 12A, 12B est constitué selon l'une des constitutions parmi le groupe consistant en : un unique élément piézoélectrique 15 ; plusieurs éléments piézoélectriques 15 connectés en série ; plusieurs éléments piézoélectriques 15 connectés en parallèle ; un élément piézoélectrique 15 et un condensateur auxiliaire, non représenté, connectés en série ; un élément piézoélectrique 15 et un condensateur auxiliaire connectés en parallèle ; et un agencement de plusieurs branches parallèles, chaque branche comportant un ou plusieurs éléments piézoélectriques 15 connectés en série ou un condensateur auxiliaire.

Le condensateur auxiliaire est typiquement de capacité supérieure, de préférence au moins trois fois supérieure, à une capacité de référence $C_0$, décrite ci-après, du ou des éléments piézoélectriques 15.

En complément facultatif, les premier 12A et deuxième 12B ensembles piézoélectriques partagent un même matériau piézoélectrique, tout en ayant les électrodes du premier ensemble 12A distinctes de celles du deuxième ensemble 12B. Selon ce complément facultatif, les paires d'électrodes du premier ensemble 12A, et respectivement celles du deuxième ensemble 12B, couvrent des surfaces de matériau distinctes. En outre, les électrodes du premier ensemble 12A ne peuvent dans ce cas pas directement induire un champ électrique significatif dans la partie du matériau piézoélectrique appartenant au second ensemble 12B. Selon ce complément facultatif encore, la capacité entre l'une quelconque des électrodes du premier ensemble 12A et l'une quelconque des électrodes du second ensemble 12B est négligeable (au moins 10 fois inférieure) devant une capacité de référence $C_0$, décrite ci-après, de chacun des ensembles 12A, 12B, par exemple en n'étant pas directement en regard de part et d'autre du matériau. Cette mise en commun d'un même matériau permet par exemple de faciliter l'implémentation des premier 12A et deuxième 12B ensembles piézoélectriques (limitation du nombre de pièce(s), mise en commun des moyens de fixation) ; et aussi de synchroniser la vibration des deux ensembles 12A, 12B, sans toutefois qu'il y ait un transfert significatif d'énergie d'un ensemble à l'autre (<1/10ème de la puissance de sortie).

L'élément piézoélectrique 15 est connu en soi, et est typiquement modélisé, proche du mode de résonnance exploité, sous la forme d'un condensateur 52 et d'une branche résonante 54 connectée en parallèle du condensateur 52, le condensateur 52 et la branche résonante 54 étant connectés entre une première électrode 56 et une deuxième électrode 58 de l'élément piézoélectrique 15, comme illustré sur la modélisation de l'élément piézoélectrique 15 représentée dans une bulle 60 à la figure 1. La branche résonante 54 est typiquement une branche RLC formée d'un condensateur 62, d'une résistance 64 et d'une bobine 66 connectés en série. La capacité du condensateur 52 connecté en parallèle de la branche résonante 54 est appelée capacité parallèle, ou encore capacité bloquée, ou capacité de référence, et notée $C_0$. La tension aux bornes de l'élément piézoélectrique 15 correspond alors typiquement à la tension aux bornes du condensateur 52.

Dans la présente description, une tension dite piézoélectrique totale $V_p$ est par convention la somme de chacune des tensions aux bornes des premier 12A, et respectivement deuxième 12B, ensembles piézoélectriques. En particulier, la tension aux bornes du premier ensemble piézoélectrique 12A est notée $V_{p1}$, et celle aux bornes du deuxième ensemble piézoélectrique 12B est notée $V_{p2}$. La tension piézoélectrique totale $V_p$ est alors égale à la somme de ces tensions $V_{p1}$ et $V_{p2}$, soit $V_{p1+}V_{p2}$. Les deux ensembles piézoélectriques 12A, 12B, et les éléments piézoélectriques 15 les constituant, sont de préférence identiques, et présentent sensiblement la même tension à leurs bornes à une éventuelle tension d'offset $V_{offset}$ près, de sorte que les tensions $V_{p1}$ et $V_{p2}$ sont égales à $V_p/2+/-V_{offset}$, selon les équations suivantes :

[1]

$$V_p = V_{p1} + V_{p2}$$

[2]

$$V_{p1} = \frac{V_p}{2} + V_{offset} \ \text{ et } \ V_{p2} = \frac{V_p}{2} - V_{offset}$$

La tension $V_{offset}$ est une composante sensiblement constante à l'échelle d'une période de résonance et impacte peu l'équilibre de charge ou d'énergie sur une période. Cette tension $V_{offset}$ évolue lentement au regard de la fréquence de pilotage, son ondulation est typiquement à une fréquence au moins 10 fois inférieure à la fréquence de pilotage des ensembles piézoélectriques 12A, 12B. Par ailleurs, lorsque l'on fait la somme des tensions $V_{p1}+V_{p2}$, cette tension d'offset $V_{offset}$ disparait, et on obtient bien la tension piézoélectrique totale $V_p$, telle que décrite dans les différents cycles. En pratique, cette tension d'offset $V_{offset}$ n'impacte pas la loi de pilotage, et autorise des potentiels $V_{inn}$ et $V_{outn}$ complètement indépendants en basse fréquence.

Dans l'exemple de la figure 4 où le convertisseur d'énergie électrique 10 est configuré pour délivrer les première $V_{out\_1}$ et deuxième $V_{out\_2}$ tensions de sortie et comprend alors deux couples de premier 12A et deuxième 12B ensembles piézoélectriques, la tension piézoélectrique totale pour un premier couple de premier 12A et deuxième 12B ensembles piézoélectriques associé à la première tension de sortie $V_{out\_1}$ est notée $V_{p\_1}$, et celle pour un deuxième couple de premier 12A et deuxième 12B ensembles piézoélectriques associé à la deuxième tension de sortie $V_{out\_2}$ est notée $V_{p\_2}$. En particulier, la tension aux bornes du premier ensemble piézoélectrique 12A est notée $V_{p\_1,1}$ pour le premier couple et $V_{p\_2,1}$ pour le deuxième couple, et celle aux bornes du deuxième ensemble piézoélectrique 12B est notée $V_{p\_1,2}$ pour le premier couple et $V_{p\_2,2}$ pour le deuxième couple. Chaque tension piézoélectrique totale $V_{p\_1}$, $V_{p\_2}$ est alors égale à la somme de ces tensions respectives $V_{p\_1,1}$, $V_{p\_1,2}$ et $V_{p\_2,1}$, $V_{p\_2,2}$, soit $V_{p\_1,1} + V_{p\_1,2}$, et respectivement $V_{p\_2,1} + V_{p\_2,2}$. Les deux ensembles piézoélectriques 12A, 12B, et les éléments piézoélectriques 15 les constituant, sont de préférence identiques, et présentent sensiblement la même tension à leurs bornes à une éventuelle tension d'offset $V_{offset\_1}$, $V_{offset\_2}$ près, de sorte que les tensions $V_{p\_1,1}$, $V_{p\_2,1}$ et $V_{p\_1,2}$, $V_{p\_2,2}$ sont chacune égales à la moitié de la tension piézoélectrique totale $V_{p\_1}$+/- $V_{offset\_1}$, $V_{p\_2}$ +/-$V_{offset\_2}$ respective, selon les équations suivantes :

[3]

$$V_{p\_1} = \ V_{p\_1,1} + \ V_{p\_1,2}$$

[4]

$$V_{p\_1,1} = \frac{V_{p\_1}}{2} + V_{offset\_1} \ \text{ et } \ V_{p\_1,2} = \frac{V_{p\_1}}{2} - V_{offset\_1}$$

[5]

$$V_{p\_2} = \ V_{p\_2,1} + \ V_{p\_2,2}$$

[6]

$$V_{p\_2,1} = \frac{V_{p\_2}}{2} + V_{offset\_2} \ \text{ et } \ V_{p\_2,2} = \frac{V_{p\_2}}{2} - V_{offset\_2}$$

En outre, dans la présente description et comme représenté sur les figures 1, 5 et 8, la tension entre les premiers points milieux 38 est notée $V_{pa}$, et est par convention égale à la différence de potentiels ($V_{pa1}$ - $V_{pa2}$), où $V_{pa1}$ est le potentiel du premier point milieu 38 connecté au premier ensemble piézoélectrique 12A, et $V_{pa2}$ est le potentiel de l'autre premier point milieu 38 connecté au deuxième ensemble piézoélectrique 12B. La tension entre les deuxièmes points milieux 48 est notée $V_{pb}$, et est par convention égale à la différence de potentiels ($V_{pb2}$ - $V_{pb1}$), où $V_{pb1}$ est le potentiel du deuxième point milieu 48 connecté au premier ensemble piézoélectrique 12A, et $V_{pb2}$ est le potentiel de l'autre deuxième point milieu 48 connecté au deuxième ensemble piézoélectrique 12B.

Par convention et comme représenté sur les figures 1, 5 et 8, la tension aux bornes du premier ensemble piézoélectrique $V_{p1}$ est égale à la différence de potentiels ($V_{pa1}$ - $V_{pb1}$), et celle aux bornes du deuxième ensemble piézoélectrique $V_{p2}$ est égale à la différence de potentiels ($V_{pb2}$ - $V_{pa2}$).

Dans l'exemple de la figure 4 où le convertisseur d'énergie électrique 10 comprend deux couples de premier 12A et deuxième 12B ensembles piézoélectriques et deux deuxièmes ponts de commutation 40_1, 40_2, la tension entre les premiers points milieux 38 est aussi notée $V_{pa}$, et est par convention égale à la différence de potentiels ($V_{pa1}$ - $V_{pa2}$), où

$V_{pa1}$ est le potentiel du premier point milieu 38 connecté au premier ensemble piézoélectrique 12A, et $V_{pa2}$ est le potentiel de l'autre premier point milieu 38 connecté au deuxième ensemble piézoélectrique 12B. La tension entre les deuxièmes points milieux 48 est notée $V_{pb\_1}$ pour le deuxième pont de commutation 40_1 associé à la première tension de sortie $V_{out\_1}$, est par convention égale à la différence de potentiels ($V_{pb2,1} - V_{pb1,1}$), où $V_{pb1,1}$ est le potentiel du deuxième point milieu 48 connecté au premier ensemble piézoélectrique 12A, et $V_{pb2,1}$ est le potentiel de l'autre deuxième point milieu 48 connecté au deuxième ensemble piézoélectrique 12B, ceci pour le deuxième pont de commutation 40_1 associé à la première tension de sortie $V_{out\_1}$. De manière analogue, la tension entre les deuxièmes points milieux 48 est notée $V_{pb\_2}$ pour le deuxième pont de commutation 40_2 associé à la deuxième tension de sortie $V_{out\_2}$, est par convention égale à la différence de potentiels ($V_{pb2,2} - V_{pb1,2}$), où $V_{pb1,2}$ est le potentiel du deuxième point milieu 48 connecté au premier ensemble piézoélectrique 12A, et $V_{pb2,2}$ est le potentiel de l'autre deuxième point milieu 48 connecté au deuxième ensemble piézoélectrique 12B, ceci pour le deuxième pont de commutation 40_2 associé à la deuxième tension de sortie $V_{out\_2}$.

Par convention et comme représenté sur la figure 4, la tension aux bornes du premier ensemble piézoélectrique $V_{p\_1,1}$ du premier couple est égale à la différence de potentiels ($V_{pa1} - V_{pb1,1}$), et celle aux bornes du deuxième ensemble piézoélectrique $V_{p\_1,2}$ du premier couple est égale à la différence de potentiels ($V_{pb2,1} - V_{pa2}$). De même, la tension aux bornes du premier ensemble piézoélectrique $V_{p\_2,1}$ du deuxième couple est égale à la différence de potentiels ($V_{pa1} - V_{pb1,2}$), et celle aux bornes du deuxième ensemble piézoélectrique $V_{p\_2,2}$ du deuxième couple est égale à la différence de potentiels ($V_{pb2,2} - V_{pa2}$).

La fréquence de résonance est la fréquence à laquelle oscille l'élément piézoélectrique 15 et par conséquent son courant $I_L$, visible sur la figure 1. Le cycle de conversion est synchronisé sur un mouvement mécanique de l'élément piézoélectrique 15, et la fréquence du pilotage est alors calée sur la fréquence d'oscillation mécanique. En pratique, cette fréquence d'oscillation dépend du point de fonctionnement du convertisseur 10 : valeurs des trois paliers de tension et du courant de sortie. En fonction du point de fonctionnement, cette fréquence d'oscillation évolue typiquement entre la fréquence de résonance dite série de l'élément piézoélectrique 15 ($\omega_s = 1/\sqrt{(L_r . C_r)}$ où $L_r$ et $C_r$ correspondent aux inductance et capacité de la branche résonante 54 et la fréquence de résonance dite parallèle de l'élément piézoélectrique 15 ($\omega_p = 1/\sqrt{(L_r . C_r . C_0/(C_r + C_0))}$), également respectivement appelés fréquence de résonance et fréquence d'antirésonance de l'élément piézoélectrique 15. La fréquence de fonctionnement du convertisseur 10 est alors comprise entre ces deux fréquences de résonance et d'antirésonance de l'élément piézoélectrique 15. Le point de fonctionnement varie lentement au regard de la fréquence d'oscillation de l'élément piézoélectrique 15. Le point de fonctionnement évolue typiquement à moins de 10kHz, alors que la fréquence d'oscillation de l'élément piézoélectrique 15 est typiquement supérieure ou égale à 100kHz. De ce fait, la fréquence de fonctionnement du convertisseur 10 évolue peu d'une période à la suivante.

D'une manière générale, pour le convertisseur d'énergie électrique 10 avec les ensembles piézoélectriques 12A, 12B et piloté par le dispositif électronique de pilotage 20, le nombre de phases II, IV, VI à tension sensiblement constante est typiquement d'au moins 2, de préférence égal à 3, tout en pouvant être supérieur ou égal à 4 avec la mise en œuvre du pilotage décrit dans la demande FR 21 07345 déposée le 7 juillet 2021.

Chaque phase II, IV, VI à tension sensiblement constante est susceptible d'être obtenue à partir d'une combinaison des tensions d'entrée et de sortie, en valeur positive ou négative. Le convertisseur d'énergie 10 permet alors d'échanger de l'énergie durant les phases II, IV, VI à tension sensiblement constante, et par voie de conséquence, avec les combinaisons de tensions utilisées pour obtenir ces phases II, IV, VI à tension sensiblement constante. Il est notamment possible de transférer de l'énergie d'une phase à tension sensiblement constante de faible tension vers une phase à tension sensiblement constante de tension plus élevée, et par le jeu des combinaisons précitées obtenir au final un convertisseur abaisseur de tension, ce qui peut paraître contre-intuitif. Inversement, il est également possible de transférer de l'énergie d'une phase à tension sensiblement constante de tension élevée vers une phase à tension sensiblement constante de tension plus faible, et par le jeu des combinaisons précitées obtenir au final un convertisseur élévateur de tension. L'homme du métier comprendra alors qu'il est possible d'avoir un cycle élévateur vu par les ensembles piézoélectriques 12A, 12B alors que le convertisseur d'énergie électrique 10 est un convertisseur abaisseur, et inversement d'avoir un cycle abaisseur vu par les ensembles piézoélectriques 12A, 12B alors que le convertisseur d'énergie électrique 10 est un convertisseur élévateur.

Par convention, si une puissance est fournie aux ensembles piézoélectriques 12A, 12B lors de la phase II, IV, VI à tension sensiblement constante correspondant à la tension la plus élevée au cours d'un cycle de résonance, alors le cycle est considéré comme un cycle abaisseur pour les ensembles piézoélectriques 12A, 12B. Inversement, si une puissance est débitée, ou encore tiré, depuis les ensembles piézoélectriques 12A, 12B lors de ladite phase II, IV, VI à tension sensiblement constante pour laquelle la tension est la plus élevée au cours du cycle de résonance, alors le cycle est considéré comme un cycle élévateur pour les ensembles piézoélectriques 12A, 12B. Comme indiqué précédemment, le cycle de conversion vu par les ensembles piézoélectriques 12A, 12B est susceptible d'être un cycle élévateur alors que le convertisseur d'énergie électrique 10 fonctionne en convertisseur abaisseur, et inversement le cycle de conversion vu par les ensembles piézoélectriques 12A, 12B est susceptible d'être un cycle abaisseur alors que le convertisseur d'énergie électrique 10 fonctionne en convertisseur élévateur.

Le dispositif électronique de pilotage 20 est configuré pour piloter le convertisseur d'énergie électrique 10, en particulier pour piloter la commande des interrupteurs 36, 46 du convertisseur, afin d'alterner des phases II, IV, VI à tension sensiblement constante aux bornes des ensembles piézoélectriques 12A, 12B et des phases I, III, V à charge sensiblement constante, c'est-à-dire en circuit sensiblement ouvert, aux bornes desdits ensembles piézoélectriques 12A, 12B.

Le dispositif électronique de pilotage 20 est par exemple réalisé sous forme d'un circuit électronique comportant un ou plusieurs composants électroniques.

En variante, le dispositif électronique de pilotage 20 est réalisé sous forme d'un composant logique programmable, tel qu'un FPGA (de l'anglais *Field Programmable Gate Array*), ou sous forme d'un circuit intégré, tel qu'un ASIC (de l'anglais *Application Specific Integrated Circuit*) ou encore sous forme d'un calculateur, tel qu'un microcontrôleur, un processeur.

Selon l'invention, le dispositif électronique de pilotage 20 est configuré pour, lors de chaque phase I, III, V à charge sensiblement constante, commander en position fermée en même temps au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B, et commander en position ouverte tous les autres interrupteurs 36, 46 des premières et deuxièmes branches de commutation 32, 42.

Autrement dit, lors de chaque phase I, III, V à charge sensiblement constante, au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B sont en position fermée en même temps, tous les autres interrupteurs 36, 46 des premières et deuxièmes branches de commutation 32, 42 étant en position ouverte.

En d'autres termes, lors de chaque phase I, III, V à charge sensiblement constante, à chaque instant au plus un interrupteur respectif parmi les interrupteurs 36A, 46A connectés directement au premier ensemble piézoélectrique 12A est en position fermée, et au plus un interrupteur respectif parmi les interrupteurs 36B, 46B connectés directement au deuxième ensemble piézoélectrique 12B est en position fermée, et tous les autres interrupteurs 36, 46 des premières et deuxièmes branches de commutation 32, 42 sont en position ouverte.

Dans les exemples des figures 1, 5 et 8, lors de chaque phase I, III, V à charge sensiblement constante, au plus un interrupteur respectif parmi les interrupteurs $K_1$, $K_2$, $K_5$, $K_6$ est en position fermée, et au plus un interrupteur respectif parmi les interrupteurs $K_3$, $K_4$, $K_7$, $K_8$ est en position fermée, tous les autres interrupteurs des premières et deuxièmes branches de commutation 32, 42 étant en position ouverte.

Dans l'exemple de la figure 4 où le convertisseur d'énergie électrique 10 est configuré pour délivrer les première $V_{out\_1}$ et deuxième $V_{out\_2}$ tensions de sortie distinctes respectives, et comprend alors deux couples de premier 12A et deuxième 12B ensembles piézoélectriques et deux deuxièmes ponts de commutation 40_1, 40_2, d'une part pour la conversion de la tension d'entrée $V_{in}$ en la première tension de sortie $V_{out\_1}$ via le premier pont de commutation 30 et le deuxième pont de commutation 40_1 associé à la première tension de sortie $V_{out\_1}$, lors de chaque phase I, III, V à charge sensiblement constante, au plus un interrupteur respectif parmi les interrupteurs $K_{1,1}$, $K_{2,1}$, $K_5$, $K_6$ est en position fermée, et au plus un interrupteur respectif parmi les interrupteurs $K_{3,1}$, $K_{4,1}$, $K_7$, $K_8$ est en position fermée, tous les autres interrupteurs des ponts de commutation 30, 40_1 étant en position ouverte. D'autre part pour la conversion de la tension d'entrée $V_{in}$ en la deuxième tension de sortie $V_{out\_2}$ via le premier pont de commutation 30 et le deuxième pont de commutation 40_2 associé à la deuxième tension de sortie $V_{out\_2}$, lors de chaque phase I, III, V à charge sensiblement constante, au plus un interrupteur respectif parmi les interrupteurs $K_{1,2}$, $K_{2,2}$, $K_5$, $K_6$ est en position fermée, et au plus un interrupteur respectif parmi les interrupteurs $K_{3,2}$, $K_{4,2}$, $K_7$, $K_8$ est en position fermée, tous les autres interrupteurs des ponts de commutation 30, 40_2 étant en position ouverte.

En complément, le dispositif électronique de pilotage 20 est configuré pour, lors des phases II, IV, VI à tension sensiblement constante aux bornes des ensembles piézoélectriques 12A, 12B, piloter la commande des interrupteurs 36, 46 du convertisseur 10, afin d'avoir la valeur $V_a$, $V_b$, $V_c$ de la tension de chacune des phases II, IV, VI à tension sensiblement constante distincte de la valeur nulle.

Selon ce complément, le dispositif électronique de pilotage 20 est de préférence configuré pour, lors des phases II, IV, VI à tension sensiblement constante aux bornes des ensembles piézoélectriques 12A, 12B, piloter la commande des interrupteurs 36, 46 du convertisseur 10, afin d'avoir la valeur $V_a$, $V_b$, $V_c$ de la tension de chacune des phases II, IV, VI à tension sensiblement constante choisie parmi le groupe consistant en : différence $V_{in} - V_{out}$ entre la valeur de la tension d'entrée $V_{in}$ et celle de la tension de sortie $V_{out}$ ; différence $V_{out} - V_{in}$ entre la valeur de la tension de sortie $V_{out}$ et celle de la tension d'entrée $V_{in}$ ; somme $V_{in} + V_{out}$ des valeurs des tensions d'entrée $V_{in}$ et de sortie $V_{out}$ ; et opposé de la somme $-V_{in} -V_{out}$ des valeurs des tensions d'entrée $V_{in}$ et de sortie $V_{out}$.

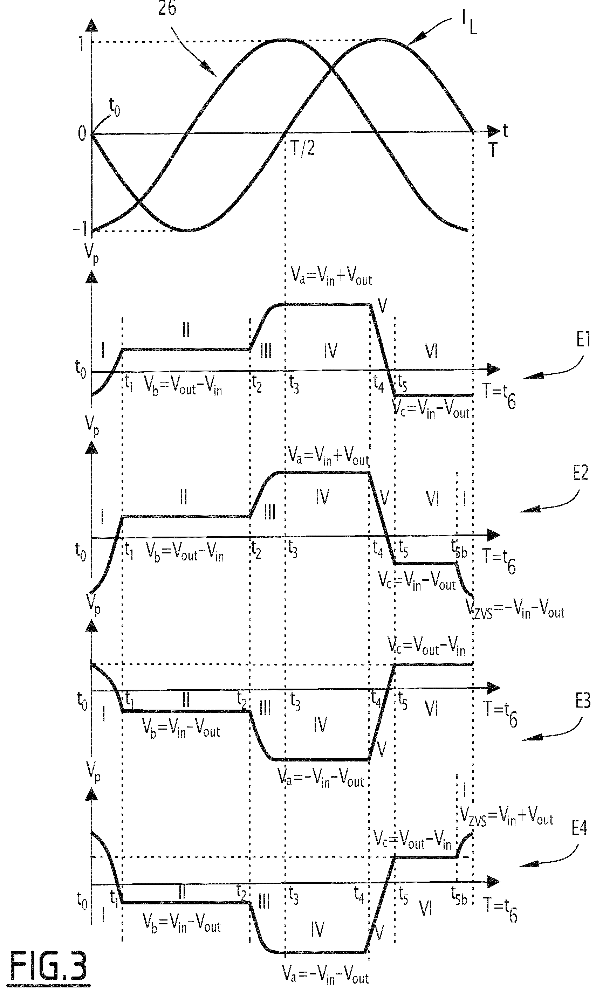

Le fonctionnement du convertisseur 10 dans l'exemple de la figure 1 va désormais être expliqué selon quatre configurations abaisseur de tension, à savoir une première configuration abaisseur A1, une deuxième configuration abaisseur A2, une troisième configuration abaisseur A3 et une quatrième configuration abaisseur A4 en regard de la figure 2 ; puis selon quatre configurations élévateur de tension, à savoir une première configuration élévateur E1, une deuxième configuration élévateur E2, une troisième configuration élévateur E3 et une quatrième configuration élévateur E4 en regard de la figure 3.

Le procédé de pilotage du convertisseur d'énergie électrique 10 est alors mis en œuvre par le dispositif électronique de pilotage 20 et comprend la commande, lors d'un cycle respectif de résonance des ensembles piézoélectriques 12A,12B, d'une commutation de chacun des interrupteurs 36, 46 pour alterner des phases II, IV, VI à tension sensiblement constante aux bornes des ensembles piézoélectriques 12A,12B et des phases I, III, V à charge sensiblement constante aux bornes desdits ensembles piézoélectriques 12A,12B,

Pour chacune des configurations abaisseur, respectivement élévateur, et selon l'invention, lors de chaque phase I, III, V à charge sensiblement constante, au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B sont commandés en position fermée en même temps, et tous les autres interrupteurs 36, 46 des premières et deuxièmes branches de commutation 32, 42 sont commandés en position ouverte.

L'homme du métier notera que par configuration très élévateur, on entend typiquement une configuration où le gain, c'est-à-dire le ratio de la tension de sortie $V_{out}$ divisée par la tension d'entrée $V_{in}$, est supérieur à 2, i.e. $V_{out}/V_{in} > 2$. Corollairement, par configuration très abaisseur, on entend typiquement une configuration où le gain, c'est-à-dire le ratio de la tension de sortie $V_{out}$ par la tension d'entrée $V_{in}$, est inférieur à 1/2, i.e. $V_{out}/V_{in} < 1/2$.

De même, par configuration élévateur, on entend typiquement une configuration où ledit gain est compris entre 1 et 2, i.e. $V_{in} < V_{out} < 2V_{in}$. Corollairement, par configuration abaisseur, on entend typiquement une configuration où ledit gain est compris entre 1/2 et 1, i.e. $V_{in}/2 < V_{out} < V_{in}$.

## Configuration abaisseur A1

Par convention, pour la première configuration abaisseur A1, le palier de tension le plus élevé pour la tension piézoélectrique totale $V_p$ est celui à la valeur $V_a$. Durant ce palier, une puissance est fournie aux ensembles piézoélectriques 12A, 12B. Par convention, le courant $I_L$ circulant dans les éléments piézoélectriques 15, i.e. dans les ensembles piézoélectriques 12A, 12B, est orienté de sorte à être positif durant ce palier de tension à la valeur $V_a$. Par conséquent, à charge constante, la tension piézoélectrique totale $V_p$ tend à diminuer lorsque le courant $I_L$ est positif, et corollairement à augmenter lorsque le courant $I_L$ est négatif.

De l'instant temporel $t_0$ à l'instant temporel $t_1$, correspondant à une première phase I, le signe du courant $I_L$ circulant dans les éléments piézoélectriques 15 conduit à une augmentation de la tension piézoélectrique totale $V_p$. La tension piézoélectrique totale $V_p$ passe de la valeur $V_c$ égale à $-V_{in}-V_{out}$ à la valeur $V_b$ égale à $-V_{in}+V_{out}$. Seule la tension $V_{pb}$ a besoin d'être modifiée, elle doit passer de $-V_{out}$ à $+V_{out}$, ce qu'elle fait naturellement avec l'augmentation de la tension piézoélectrique totale $V_p$, alors que la tension $V_{pa}$ reste constante et fixée à $-V_{in}$ via le maintien des interrupteurs $K_5$ et $K_8$ fermés.

Durant cette première phase I, à charge sensiblement constante, seuls les interrupteurs $K_5$ et $K_8$ sont alors en position fermée.

En l'instant temporel $t_1$, les tensions $V_{pa}$ et $V_{pb}$ sont donc déjà repositionnées sur les valeurs du palier de tension suivant, et la fermeture des interrupteurs $K_1$, $K_4$ s'effectue en mode ZVS, c'est-à-dire avec une tension sensiblement nulle à leurs bornes avant leur fermeture. Si les interrupteurs $K_1$ et $K_4$ disposent d'une diode inverse intrinsèque ou d'une diode additionnelle placée en parallèle, leur mise en conduction peut se faire naturellement au regard du signe du courant. Les interrupteurs $K_5$, $K_8$ étaient déjà fermés.

De l'instant temporel $t_1$ à l'instant temporel $t_2$, correspondant à une deuxième phase II, les interrupteurs $K_1$, $K_4$, $K_5$ et $K_8$ sont en position fermée. La tension piézoélectrique totale $V_p$ est égale à $-V_{in}+V_{out}$. Une puissance positive est tirée sur la tension d'entrée $V_{in}$ en même temps qu'une puissance positive est fournie à la tension de sortie $V_{out}$.

De l'instant temporel $t_2$ à l'instant temporel $t_3$, correspondant à une troisième phase III, le signe du courant $I_L$ conduit à une augmentation de la tension piézoélectrique totale $V_p$. La tension piézoélectrique totale $V_p$ passe donc de $-V_{in}+V_{out}$ à $+V_{in}-V_{out}$. Vu des ensembles piézoélectriques 12A,12B, l'application de la valeur $V_a$ en l'instant temporel $t_3$ n'induit pas de variation de tension à ses bornes et de ce point de vue la fermeture des interrupteurs en l'instant temporel $t_3$ n'induit pas de pertes pour les ensembles piézoélectriques 12A,12B.

Toutefois, la tension aux bornes des interrupteurs n'est pas nulle et leur fermeture induit des pertes propres à l'énergie stockée dans leurs capacités parasites, par exemple leur capacité de sortie. En effet, la tension piézoélectrique totale $V_p$ initiale vaut $-V_{in}+V_{out}$, la tension $V_{pa}$ étant égale à $-Vin$ et la tension $V_{pb}$ égale à $+V_{out}$, et le signe du courant $I_L$ permet une augmentation de la tension piézoélectrique totale $V_p$ contribuant à l'augmentation de la tension $V_{pa}$, mais pas à la diminution de la tension $V_{pb}$ qui doit passer de $+V_{out}$ à $-V_{out}$. Donc, en l'instant temporel $t_3$, la tension $V_{pb}$ est toujours à $+V_{out}$ tandis que la tension $V_{pa}$ est égale à la tension piézoélectrique totale $V_p$ moins la tension $V_{pb}$, soit $(+V_{in}-V_{out})-V_{out}$, soit $V_{in}-2V_{out}$.

Avant leur fermeture en l'instant temporel $t_3$, les interrupteurs $K_2$ et $K_3$ ont une différence de potentiel $V_{out}$ à leurs

bornes, ce qui induit des pertes lors de leur fermeture. Avant leur fermeture en l'instant temporel $t_3$, les interrupteurs $K_6$ et $K_7$ ont une différence de potentiel $(V_{in}-V_{pa})/2$, soit $(V_{in}-(V_{in}-2V_{out}))/2 = V_{out}$ à leurs bornes, ce qui induit des pertes lors de leur fermeture.

En pratique, si les interrupteurs $K_2$ et $K_3$ disposent d'une diode inverse (intrinsèque ou additionnelle placée en parallèle), au regard du signe du courant $I_L$, les interrupteurs $K_2$ et $K_3$ n'ont pas besoin d'être forcés à la fermeture, mais peuvent se fermer naturellement un peu plus tard. Dans ce cas, l'énergie stockée dans leur capacité parasite de sortie sera dissipée dans les interrupteurs $K_6$ et $K_7$. Au niveau du mode commun, si les interrupteurs $K_2$ et $K_3$ sont sensiblement identiques et que $K_6$ et $K_7$ sont sensiblement identiques, et que les interrupteurs $K_6$ et $K_7$ sont fermés sensiblement en même temps, (de même pour les interrupteurs $K_2$ et $K_3$ s'ils sont commandés à la fermeture de manière forcée), alors, de par la symétrie, le courant tiré sur le potentiel $V_{inp}$ s'oppose au courant tiré sur le potentiel $V_{inn}$, et de même pour le potentiel $V_{outp}$ et le potentiel $V_{outn}$, et il n'y a pas de courant de mode commun injecté sur la tension de sortie $V_{out}$.

Durant cette troisième phase III, à charge sensiblement constante, seuls les interrupteurs $K_1$ et $K_4$ sont alors passants ou commandés en position fermée.

De l'instant temporel $t_3$ à l'instant temporel $t_4$, correspondant à une quatrième phase IV, les interrupteurs $K_2$, $K_3$, $K_6$ et $K_7$ sont passants ou fermés. La tension piézoélectrique totale $V_p$ est égale à $V_{in}-V_{out}$. Une puissance positive est tirée sur la tension d'entrée $V_{in}$ en même temps qu'une puissance positive est fournie à la tension de sortie $V_{out}$.

De l'instant temporel $t_4$ à l'instant temporel $t_5$, correspondant à une cinquième phase V, le signe du courant $I_L$ conduit à une diminution de la tension piézoélectrique totale $V_p$. La tension piézoélectrique totale $V_p$ passe donc de $+V_{in}-V_{out}$ à $-V_{in}-V_{out}$. Seule la tension $V_{pa}$ a besoin d'être modifiée, et doit passer de $+V_{in}$ à $-V_{in}$, ce qu'elle fait naturellement avec la diminution de la tension piézoélectrique totale $V_p$, tandis que la tension $V_{pb}$ reste constante et fixée à $-V_{out}$ via le maintien des interrupteurs $K_2$ et $K_3$ passants (soit en maintenant une commande de fermeture, soit naturellement via leur diode inverse intrinsèque, soit encore via une diode parallèle additionnelle).

Durant cette cinquième phase V, à charge sensiblement constante, seuls les interrupteurs $K_2$ et $K_3$ sont alors en position fermée.

En l'instant temporel $t_5$, la tension $V_{pa}$ et la tension $V_{pb}$ sont donc déjà repositionnées sur les valeurs du palier de tension suivant, et la fermeture des interrupteurs $K_5$, $K_8$ s'effectue en mode ZVS. Si les interrupteurs $K_5$ et $K_8$ disposent d'une diode inverse intrinsèque ou d'une diode additionnelle placée en parallèle, leur mise en conduction peut se faire naturellement au regard du signe du courant. Les interrupteurs $K_2$, $K_3$ étaient déjà passants ou fermés.

De l'instant temporel $t_5$ à l'instant temporel $t_6$ (ou l'instant temporel $t_0$), correspondant à une sixième phase VI, les interrupteurs $K_2$, $K_3$, $K_5$ et $K_8$ sont passants ou fermés. La tension piézoélectrique totale $V_p$ est égale à $-V_{in}-V_{out}$. Une puissance positive est restituée à la tension d'entrée $V_{in}$ en même temps qu'une puissance positive est fournie à la tension de sortie $V_{out}$.

**Configuration abaisseur A2**

La deuxième configuration abaisseur A2 diffère de la première configuration abaisseur A1, décrite précédemment, seulement en ce qu'elle intègre une excursion à la tension $V_{ZVS}$ égale à $+V_{in}+V_{out}$ en l'instant temporel $t_3$. Cette excursion de tension permet de passer du palier de tension piézoélectrique totale $V_p$ égal à $-V_{in}+V_{out}$ au palier de tension piézoélectrique totale $V_p$ égal à $V_{in}-V_{out}$ en commutation ZVS au niveau des interrupteurs.

Ce passage se fait en deux étapes, une première étape de l'instant temporel $t_2$ à l'instant temporel $t_3$ pour passer de la tension piézoélectrique totale $V_p$ égale à $-V_{in}+V_{out}$ à la tension piézoélectrique totale $V_p$ égale à $V_{in}+V_{out}$, puis une seconde étape de l'instant temporel $t_3$ à l'instant temporel $t_{3b}$ pour passer de la tension piézoélectrique totale $V_p$ égale à $V_{in}+V_{out}$ à la tension piézoélectrique totale $V_p$ égale à $V_{in}-V_{out}$.

De l'instant temporel $t_2$ à l'instant temporel $t_3$, correspondant à la première étape de la troisième phase III, le signe du courant $I_L$ conduit à une augmentation de la tension piézoélectrique totale $V_p$. La tension piézoélectrique totale $V_p$ passe donc de $-V_{in}+V_{out}$ à $V_{in}+V_{out}$. Seule la tension $V_{pa}$ a besoin d'être modifiée, et doit passer de $-V_{in}$ à $+V_{in}$, ce qu'elle fait naturellement avec l'augmentation de la tension piézoélectrique totale $V_p$, tandis que la tension $V_{pb}$ reste constante et fixée à $+V_{out}$ via le maintien des interrupteurs $K_1$ et $K_4$ passants (soit en maintenant une commande de fermeture, soit naturellement via leur diode inverse intrinsèque, soit encore via une diode parallèle additionnelle).

Durant la première étape de la troisième phase III, à charge sensiblement constante, seuls les interrupteurs $K_1$ et $K_4$ sont alors passants ou commandés en position fermée.

En l'instant temporel $t_3$, la tension $V_{pa}$ et la tension $V_{pb}$ sont donc pré-positionnées sur respectivement $+V_{in}$ et $+V_{out}$, et la fermeture des interrupteurs $K_6$, $K_7$ s'effectue en mode ZVS. Les interrupteurs $K_6$ et $K_7$ se ferment, tandis que les interrupteurs $K_1$ et $K_4$ s'ouvrent.

De l'instant temporel $t_3$ à l'instant temporel $t_{3b}$, le signe du courant $I_L$ conduit à une diminution de la tension piézoélectrique totale $V_p$. La tension piézoélectrique totale $V_p$ passe donc de $V_{in}+V_{out}$ à $V_{in}-V_{out}$. Seule la tension $V_{pb}$ a besoin d'être modifiée, et doit passer de $+V_{out}$ à $-V_{out}$, ce qu'elle fait naturellement avec la diminution de la tension piézoélectrique totale $V_p$, tandis que la tension $V_{pa}$ reste constante et fixée à $+V_{in}$ via le maintien des interrupteurs $K_6$ et $K_7$

fermés.

Durant la deuxième étape de la troisième phase III, à charge sensiblement constante, seuls les interrupteurs $K_6$ et $K_7$ sont alors commandés en position fermée.

En l'instant temporel $t_{3b}$, la tension $V_{pa}$ et la tension $V_{pb}$ sont donc déjà repositionnées sur les valeurs du palier de tension suivant, et la fermeture des interrupteurs $K_2$, $K_3$ s'effectue en mode ZVS. Si les interrupteurs $K_2$ et $K_3$ disposent d'une diode inverse intrinsèque ou d'une diode additionnelle placée en parallèle, leur mise en conduction peut se faire naturellement au regard du signe du courant. Les interrupteurs $K_6$, $K_7$ étaient déjà fermés. A l'instant temporel $t_{3b}$, les interrupteurs $K_2$ et $K_3$ se ferment ou deviennent passants.

## Configuration abaisseur A3

Par convention, pour la troisième configuration abaisseur A3, le palier de tension le plus élevé pour la tension piézoélectrique totale $V_p$ est celui à la valeur $V_c$. Durant ce palier, une puissance est débitée, ou encore tirée, depuis les ensembles piézoélectriques 12A, 12B. Par convention, le courant $I_L$ circulant dans les éléments piézoélectriques 15, i.e. dans les ensembles piézoélectriques 12A, 12B, est orienté de sorte à être positif durant ce palier de tension à la valeur $V_c$. Par conséquent, à charge constante, la tension piézoélectrique totale $V_p$ tend à augmenter lorsque le courant $I_L$ est positif, et corollairement à diminuer lorsque le courant $I_L$ est négatif.

De l'instant temporel $t_0$ à l'instant temporel $t_1$, correspondant à la première phase I, le signe du courant $I_L$ conduit à une diminution de la tension piézoélectrique totale $V_p$. La tension piézoélectrique totale $V_p$ passe donc de la valeur $V_c$ égale à $V_{in}+V_{out}$ à la valeur $V_b$ égale à $V_{in}-V_{out}$. Seule la tension $V_{pb}$ a besoin d'être modifiée, et doit passer de $+V_{out}$ à $-V_{out}$, ce qu'elle fait naturellement avec la diminution de la tension piézoélectrique totale $V_p$, tandis que la tension $V_{pa}$ reste constante et fixée à $+V_{in}$ via le maintien des interrupteurs $K_6$ et $K_7$ fermés.

Durant cette première phase I, à charge sensiblement constante, seuls les interrupteurs $K_6$ et $K_7$ sont alors commandés en position fermée.

En l'instant temporel $t_1$, la tension $V_{pa}$ et la tension $V_{pb}$ sont donc déjà repositionnées sur les valeurs du palier de tension suivant, et la fermeture des interrupteurs $K_2$, $K_3$ s'effectue en mode ZVS. Si les interrupteurs $K_2$ et $K_3$ disposent d'une diode inverse intrinsèque ou d'une diode additionnelle placée en parallèle, leur mise en conduction peut se faire naturellement au regard du signe du courant. Les interrupteurs $K_6$, $K_7$ étaient déjà fermés.

De l'instant temporel $t_1$ à l'instant temporel $t_2$, correspondant à la deuxième phase II, les interrupteurs $K_2$, $K_3$, $K_6$ et $K_7$ sont passants ou fermés. La tension piézoélectrique totale $V_p$ est égale à $V_{in}-V_{out}$. Une puissance positive est tirée sur la tension d'entrée $V_{in}$ en même temps qu'une puissance positive est fournie à la tension de sortie $V_{out}$.

De l'instant temporel $t_2$ à l'instant temporel $t_3$, correspondant à la troisième phase III, le signe du courant $I_L$ conduit à une diminution de la tension piézoélectrique totale $V_p$. La tension piézoélectrique totale $V_p$ passe donc de $V_{in}-V_{out}$ à $-V_{in}+V_{out}$. Vu des ensembles piézoélectriques 12A,12B, l'application de la valeur $V_a$ en l'instant temporel $t_3$ n'induit pas de variation de tension à ses bornes et de ce point de vue la fermeture des interrupteurs en l'instant temporel $t_3$ n'induit pas de pertes pour les ensembles piézoélectriques 12A,12B.

Toutefois, la tension aux bornes des interrupteurs n'est pas nulle et leur fermeture induit des pertes propres à l'énergie stockée dans leurs capacités parasites, par exemple leur capacité parasite de sortie. En effet, la tension piézoélectrique totale $V_p$ initiale vaut $V_{in}-V_{out}$, la tension $V_{pa}$ étant égale à $V_{in}$ et la tension $V_{pb}$ étant égale à $-V_{out}$ ; et le signe du courant $I_L$ permet une diminution de la tension piézoélectrique totale $V_p$, contribuant à la diminution de la tension $V_{pa}$, mais pas à l'augmentation de la tension $V_{pb}$ qui doit passer de $-V_{out}$ à $+V_{out}$. Donc, en l'instant temporel $t_3$, la tension $V_{pb}$ est toujours à $-V_{out}$ tandis que la tension $V_{pa}$ égale à $V_p$ moins la tension $V_{pb}$, soit $(-V_{in}+V_{out})-(-V_{out}) = -V_{in}+2V_{out}$.

Avant leur fermeture en l'instant temporel $t_3$, les interrupteurs $K_1$ et $K_4$ ont une différence de potentiel $V_{out}$ à leurs bornes, ce qui induit des pertes lors de leur fermeture. Avant leur fermeture en l'instant temporel $t_3$, les interrupteurs $K_5$ et $K_8$ ont une différence de potentiel $(V_{in}+V_{pa})/2 = (V_{in}+(-V_{in}+2V_{out}))/2 = V_{out}$ à leurs bornes, ce qui induit des pertes lors de leur fermeture. En pratique, si les interrupteurs $K_1$ et $K_4$ disposent d'une diode inverse (intrinsèque ou additionnel placée en parallèle), au regard du signe du courant $I_L$, les interrupteurs $K_1$ et $K_4$ n'ont pas besoin d'être forcés à la fermeture, mais peuvent se fermer naturellement un peu plus tard. Dans ce cas, l'énergie stockée dans leur capacité de sortie sera dissipée dans les interrupteurs $K_5$ et $K_8$. Au niveau du mode commun, si les interrupteurs $K_1$ et $K_4$ sont sensiblement identiques et que les interrupteurs $K_5$ et $K_8$ sont sensiblement identiques, et que les interrupteurs $K_5$ et $K_8$ sont fermés sensiblement en même temps, (de même pour les interrupteurs $K_1$ et $K_4$ s'ils sont commandés à la fermeture de manière forcée), alors, de par la symétrie, le courant tiré sur le potentiel $V_{inp}$ s'oppose au courant tiré sur le potentiel $V_{inn}$, et de même pour le potentiel $V_{outp}$ et le potentiel $V_{outn}$, et il n'y a donc pas de courant de mode commun injecté sur la tension de sortie $V_{out}$.

Durant cette troisième phase III, à charge sensiblement constante, seuls les interrupteurs $K_2$ et $K_3$ sont passants ou commandés en position fermée.

De l'instant temporel $t_3$ à l'instant temporel $t_4$, correspondant à la quatrième phase IV, les interrupteurs $K_1$, $K_4$, $K_5$ et $K_8$ sont passants ou fermés. La tension piézoélectrique totale $V_p$ est égale à $-V_{in}+V_{out}$. Une puissance positive est tirée sur la tension d'entrée $V_{in}$ en même temps qu'une puissance positive est fournie à la tension de sortie $V_{out}$.

De l'instant temporel $t_4$ à l'instant temporel $t_5$, correspondant à la cinquième phase V, le signe du courant $I_L$ conduit à une augmentation de la tension piézoélectrique totale $V_p$. La tension piézoélectrique totale $V_p$ passe donc de $-V_{in}$ $+V_{out}$ à $V_{in}+V_{out}$. Seule la tension $V_{pa}$ a besoin d'être modifiée, et doit passer de $-V_{in}$ à $+V_{in}$, ce qu'elle fait naturellement avec l'augmentation de la tension piézoélectrique totale $V_p$, tandis que la tension $V_{pb}$ reste constante et fixée à $+V_{out}$ via le maintien des interrupteurs $K_1$ et $K_4$ passants (soit en maintenant une commande de fermeture, soit naturellement via leur diode inverse intrinsèque, soit encore via une diode parallèle additionnelle).

Durant cette cinquième phase V, à charge sensiblement constante, seuls les interrupteurs $K_1$ et $K_4$ sont alors passant ou commandés en position fermée.

En l'instant temporel $t_5$, la tension $V_{pa}$ et la tension $V_{pb}$ sont donc déjà repositionnées sur les valeurs du palier de tension suivant, et la fermeture des interrupteurs $K_6$, $K_7$ s'effectue en mode ZVS. Si les interrupteurs $K_6$ et $K_7$ disposent d'une diode inverse intrinsèque ou d'une diode additionnelle placée en parallèle, leur mise en conduction peut se faire naturellement au regard du signe du courant. Les interrupteurs $K_1$, $K_4$ étaient déjà passants ou fermés.

De l'instant temporel $t_5$ à l'instant temporel $t_6$ (ou l'instant temporel $t_0$), correspondant à la sixième phase VI, les interrupteurs $K_1$, $K_4$, $K_6$ et $K_7$ sont passants ou fermés. La tension piézoélectrique totale $V_p$ est égale à $V_{in}+V_{out}$. Une puissance positive est restituée à la tension d'entrée $V_{in}$ en même temps qu'une puissance positive est fournie à la tension de sortie $V_{out}$.

**Configuration abaisseur A4**

La quatrième configuration abaisseur A4 diffère de la troisième configuration abaisseur A3, décrite précédemment, seulement en ce qu'elle intègre une excursion à $V_{ZVS}$ égale à $-V_{in}-V_{out}$ en l'instant temporel $t_3$. Cette excursion de tension permet de passer du palier de tension piézoélectrique totale $V_p$ égal à $V_{in}-V_{out}$ au palier de tension piézoélectrique totale $V_p$ égal à $-V_{in}+V_{out}$ en commutation ZVS au niveau des interrupteurs.

Ce passage se fait en deux étapes, une première étape de l'instant temporel $t_2$ à l'instant temporel $t_3$ pour passer de la tension piézoélectrique totale $V_p$ égale à $V_{in}-V_{out}$ à la tension piézoélectrique totale $V_p$ égale à $-V_{in}-V_{out}$, puis une seconde étape de l'instant temporel $t_3$ à l'instant temporel $t_{3b}$ pour passer de la tension piézoélectrique totale $V_p$ égale à $-V_{in}-V_{out}$ à la tension piézoélectrique totale $V_p$ égale à $-V_{in}+V_{out}$.

De l'instant temporel $t_2$ à l'instant temporel $t_3$, correspondant à la troisième phase III, le signe du courant $I_L$ conduit à une diminution de la tension piézoélectrique totale $V_p$. La tension piézoélectrique totale $V_p$ passe donc de $V_{in}-V_{out}$ à $-V_{in}-V_{out}$. Seule la tension $V_{pa}$ a besoin d'être modifiée, et doit passer de $V_{in}$ à $-V_{in}$, ce qu'elle fait naturellement avec la diminution de la tension piézoélectrique totale $V_p$, tandis que la tension $V_{pb}$ reste constante et fixée à $-V_{out}$ via le maintien des interrupteurs $K_2$ et $K_3$ passants (soit en maintenant une commande de fermeture, soit naturellement via leur diode inverse intrinsèque, soit encore via une diode parallèle additionnelle).

Durant la première étape de la troisième phase III, à charge sensiblement constante, seuls les interrupteurs $K_2$ et $K_3$ sont alors passant ou commandés en position fermée.

En l'instant temporel $t_3$, la tension $V_{pa}$ et la tension $V_{pb}$ sont donc pré-positionnées sur respectivement $-V_{in}$ et $-V_{out}$, et la fermeture des interrupteurs $K_5$, $K_8$ s'effectue en mode ZVS.

A l'instant temporel $t_3$, les interrupteurs $K_5$ et $K_8$ se ferment, tandis que les interrupteurs $K_2$ et $K_3$ s'ouvrent.

De l'instant temporel $t_3$ à l'instant temporel $t_{3b}$, le signe du courant $I_L$ conduit à une augmentation de la tension piézoélectrique totale $V_p$. La tension piézoélectrique totale $V_p$ passe donc de $-V_{in}-V_{out}$ à $-V_{in}+V_{out}$. Seule la tension $V_{pb}$ a besoin d'être modifiée, et doit passer de $-V_{out}$ à $+V_{out}$, ce qu'elle fait naturellement avec l'augmentation de la tension piézoélectrique totale $V_p$, tandis que la tension $V_{pa}$ reste constante et fixée à $-V_{in}$ via le maintien des interrupteurs $K_5$ et $K_8$ fermés.

Durant la deuxième étape de la troisième phase III, à charge sensiblement constante, seuls les interrupteurs $K_5$ et $K_8$ sont alors commandés en position fermée.

En l'instant temporel $t_{3b}$, la tension $V_{pa}$ et la tension $V_{pb}$ sont donc déjà repositionnées sur les valeurs du palier de tension suivant, et la fermeture des interrupteurs $K_1$, $K_4$ s'effectue en mode ZVS. Si les interrupteurs $K_1$ et $K_4$ disposent d'une diode inverse intrinsèque ou d'une diode additionnelle placée en parallèle, leur mise en conduction peut se faire naturellement au regard du signe du courant. Les interrupteurs $K_5$, $K_8$ étaient déjà fermés. A l'instant temporel $t_{3b}$, les interrupteurs $K_1$ et $K_4$ se ferment ou deviennent passants.

L'homme du métier observera que pour les quatre configurations abaisseur de la figure 2, les interrupteurs $K_1$, $K_2$, $K_3$, $K_4$ peuvent être constitués chacun d'une simple diode, leur fermeture et ouverture s'effectuant alors naturellement.

Le fonctionnement du convertisseur 10 dans l'exemple de la figure 1 est à présent expliqué selon les quatre configurations élévateur de tension, à savoir la première configuration élévateur E1, la deuxième configuration élévateur E2, la troisième configuration élévateur E3 et la quatrième configuration élévateur E4 en regard de la figure 3.

## Configuration élévateur E1

De l'instant temporel $t_0$ à l'instant temporel $t_1$, correspondant à la première phase I, le signe du courant $I_L$ conduit à une augmentation de la tension piézoélectrique totale $V_p$. La tension piézoélectrique totale $V_p$ passe donc de la valeur $V_c$ égale à $V_{in}-V_{out}$ à la valeur $V_b$ égale à $-V_{in}+V_{out}$. Vu des ensembles piézoélectriques 12A,12B, l'application de la valeur $V_b$ en l'instant temporel $t_1$ n'induit pas de variation de tension à ses bornes et de ce point de vue la fermeture des interrupteurs en l'instant temporel $t_1$ n'induit pas de pertes pour les ensembles piézoélectriques 12A,12B.

Toutefois, la tension aux bornes des interrupteurs n'est pas nulle et leur fermeture induit des pertes propres à l'énergie stockée dans leurs capacités parasites, par exemple leur capacité parasite de sortie. En effet, la tension piézoélectrique totale $V_p$ initiale vaut $V_{in}-V_{out}$, à savoir la tension $V_{pa}$ égale à $V_{in}$ et la tension $V_{pb}$ égale à $-V_{out}$, le signe du courant $I_L$ permet une augmentation de la tension piézoélectrique totale $V_p$ et donc peut contribuer à l'augmentation de la tension $V_{pb}$, mais pas à la diminution de la tension $V_{pa}$ qui doit passer de $+V_{in}$ à $-V_{in}$. Donc, en l'instant temporel $t_1$, la tension $V_{pa}$ est toujours à $+Vin$ tandis que la tension $V_{pb}$ égale à $V_p$ moins la tension $V_{pa}$, soit $(-V_{in}+V_{out})-V_{in}$ égale à $V_{out}-2V_{in}$. Avant leur fermeture en l'instant temporel $t_1$, les interrupteurs $K_5$ et $K_8$ ont une différence de potentiel $V_{in}$ à leurs bornes, ce qui induit des pertes lors de leur fermeture. Avant leur fermeture en l'instant temporel $t_1$, les interrupteurs $K_1$ et $K_4$ ont une différence de potentiel ($V_{out}$ moins la tension $V_{pb}$)/2, soit $(V_{out}-(V_{out}-2V_{in}))/2$ égale à $V_{in}$ à leurs bornes, ce qui induit des pertes lors de leur fermeture.

En pratique, si les interrupteurs $K_1$ et $K_4$ disposent d'une diode inverse (intrinsèque ou additionnel placée en parallèle), au regard du signe du courant $I_L$, les interrupteurs $K_1$ et $K_4$ n'ont pas besoin d'être forcés à la fermeture, mais peuvent se fermer naturellement un peu plus tard. Dans ce cas, l'énergie stockée dans leur capacité de sortie sera dissipée dans les interrupteurs $K_5$ et $K_8$. Au niveau du mode commun, si les interrupteurs $K_1$ et $K_4$ sont sensiblement identiques et que les interrupteurs $K_5$ et $K_8$ sont sensiblement identiques, et que les interrupteurs $K_5$ et $K_8$ sont fermés sensiblement en même temps, (de même pour les interrupteurs $K_1$ et $K_4$ s'ils sont commandés à la fermeture de manière forcée), alors, de par la symétrie, le courant tiré sur le potentiel $V_{inp}$ s'oppose au courant tiré sur le potentiel $V_{inn}$, et de même pour le potentiel $V_{outp}$ et le potentiel $V_{outn}$, et il n'y a pas de courant de mode commun injecté sur la tension de sortie $V_{out}$.

Durant cette première phase I, à charge sensiblement constante, seuls les interrupteurs $K_6$ et $K_7$ sont alors passants ou commandés en position fermée. Durant cette première phase I, la tension piézoélectrique totale $V_p$ augmente, ce qui tend à faire augmenter les tensions $V_{pa}$ et $V_{pb}$, mais comme la tension $V_{pa}$ est déjà égale à la valeur $+V_{in}$ en l'instant temporel $t_0$, elle ne peut plus augmenter, ce qui fait passer un petit courant dans les interrupteurs $K_6$ et $K_7$, soit parce qu'ils sont fermés, soit via leur diodes inverses intrinsèques ou additionnelles.

De l'instant temporel $t_1$ à l'instant temporel $t_2$, correspondant à la deuxième phase II, les interrupteurs $K_1$, $K_4$, $K_5$ et $K_8$ sont passants ou fermés. La tension piézoélectrique totale $V_p$ est égale à $-V_{in}+V_{out}$. Une puissance positive est tirée sur la tension d'entrée $V_{in}$ en même temps qu'une puissance positive est fournie à la tension de sortie $V_{out}$.

De l'instant temporel $t_2$ à l'instant temporel $t_3$, correspondant à la troisième phase III, le signe du courant $I_L$ conduit à une augmentation de la tension piézoélectrique totale $V_p$. La tension piézoélectrique totale $V_p$ passe donc de $-V_{in}+V_{out}$ à $+V_{in}+V_{out}$. Seule la tension $V_{pa}$ a besoin d'être modifiée, elle doit passer de $-V_{in}$ à $+V_{in}$, ce qu'elle fait naturellement avec l'augmentation de la tension piézoélectrique totale $V_p$, tandis que la tension $V_{pb}$ reste constante et fixée à $+V_{out}$ via le maintien des interrupteurs $K_1$ et $K_4$ fermés.

Durant cette troisième phase III, à charge sensiblement constante, seuls les interrupteurs $K_1$ et $K_4$ sont alors commandés en position fermée.

En l'instant temporel $t_3$, la tension $V_{pa}$ et la tension $V_{pb}$ sont donc déjà repositionnées sur les valeurs du palier de tension suivant, et la fermeture des interrupteurs $K_6$, $K_7$ s'effectue en mode ZVS.

De l'instant temporel $t_3$ à l'instant temporel $t_4$, correspondant à la quatrième phase IV, les interrupteurs $K_1$, $K_4$, $K_6$ et $K_7$ sont fermés. La tension piézoélectrique totale $V_p$ est égale à $V_{in}+V_{out}$. Une puissance positive est tirée sur la tension d'entrée $V_{in}$ en même temps qu'une puissance positive est tirée sur la tension de sortie $V_{out}$.

De l'instant temporel $t_4$ à l'instant temporel $t_5$, correspondant à la cinquième phase V, le signe du courant $I_L$ conduit à une diminution de la tension piézoélectrique totale $V_p$. La tension piézoélectrique totale $V_p$ passe donc de $+V_{in}+V_{out}$ à $V_{in}-V_{out}$. Seule la tension $V_{pb}$ a besoin d'être modifiée, et doit passer de $+V_{out}$ à $-V_{out}$, ce qu'elle fait naturellement avec la diminution de la tension piézoélectrique totale $V_p$, tandis que la tension $V_{pa}$ reste constante et fixée à $+V_{in}$ via le maintien des interrupteurs $K_6$ et $K_7$ fermés.

Durant cette cinquième phase V, à charge sensiblement constante, seuls les interrupteurs $K_6$ et $K_7$ sont alors commandés en position fermée.

En l'instant temporel $t_5$, la tension $V_{pa}$ et la tension $V_{pb}$ sont donc déjà repositionnées sur les valeurs du palier de tension suivant, et la fermeture des interrupteurs $K_2$, $K_3$ s'effectue en mode ZVS. Si les interrupteurs $K_2$ et $K_3$ disposent d'une diode inverse intrinsèque ou d'une diode additionnelle placée en parallèle, leur mise en conduction peut se faire naturellement au regard du signe du courant $I_L$. Les interrupteurs $K_6$, $K_7$ étaient déjà fermés.

De l'instant temporel $t_5$ à l'instant temporel $t_6$ (ou l'instant temporel $t_0$), correspondant à la sixième phase VI, les

interrupteurs $K_6$, $K_7$, $K_2$ et $K_3$ sont passants ou fermés. La tension piézoélectrique totale $V_p$ égale à $V_{in}$-$V_{out}$. Une puissance positive est tirée sur la tension d'entrée $V_{in}$ en même temps qu'une puissance positive est fournie à la tension de sortie $V_{out}$.

**Configuration élévateur E2**

La deuxième configuration élévateur E2 diffère de la première configuration élévateur E1, décrite précédemment, seulement en ce qu'elle intègre une excursion à $V_{ZVS}$ égale à -$V_{in}$-$V_{out}$ en l'instant temporel $t_0$. Cette excursion de tension permet de passer du palier de tension piézoélectrique totale $V_p$ égal à $V_{in}$-$V_{out}$ au palier de tension piézoélectrique totale $V_p$ égal à -$V_{in}$+$V_{out}$ en commutation ZVS au niveau des interrupteurs. Ce passage se fait en deux étapes, une première étape de l'instant temporel $t_{5b}$ à l'instant temporel $t_6$ (ou l'instant temporel $t_0$) pour passer de la tension piézoélectrique totale $V_p$ égale à $V_{in}$-$V_{out}$ à la tension piézoélectrique totale $V_p$ égale à -$V_{in}$-$V_{out}$, puis une seconde étape de l'instant temporel $t_0$ à l'instant temporel $t_1$ pour passer de la tension piézoélectrique totale $V_p$ égale à -$V_{in}$-$V_{out}$ à la tension piézoélectrique totale $V_p$ égale à -$V_{in}$+$V_{out}$.

De l'instant temporel $t_{5b}$ à l'instant temporel $t_6$ (ou l'instant temporel $t_0$), le signe du courant $I_L$ conduit à une diminution de la tension piézoélectrique totale $V_p$. La tension piézoélectrique totale $V_p$ passe donc de $V_{in}$-$V_{out}$ à -$V_{in}$-$V_{out}$. Seule la tension $V_{pa}$ a besoin d'être modifiée, et doit passer de $V_{in}$ à -$V_{in}$, ce qu'elle fait naturellement avec la diminution de la tension piézoélectrique totale $V_p$, tandis que la tension $V_{pb}$ reste constante et fixée à - $V_{out}$ via le maintien des interrupteurs $K_2$ et $K_3$ passants (soit en maintenant une commande de fermeture, soit naturellement via leur diode inverse intrinsèque, soit encore via une diode parallèle additionnelle). En l'instant temporel $t_6$ (ou l'instant temporel $t_0$), la tension $V_{pa}$ et la tension $V_{pb}$ sont donc pré-positionnées sur respectivement -$V_{in}$ et -$V_{out}$, et la fermeture des interrupteurs $K_5$, $K_8$ s'effectue en mode ZVS.

Durant la première étape de cette première phase I, à charge sensiblement constante, seuls les interrupteurs $K_2$ et $K_3$ sont alors passants ou commandés en position fermée.

A l'instant temporel $t_0$, les interrupteurs $K_5$ et $K_8$ se ferment, tandis que les interrupteurs $K_2$ et $K_3$ s'ouvrent.

De l'instant temporel $t_0$ à l'instant temporel $t_1$, correspondant à la première phase I, le signe du courant $I_L$ conduit à une augmentation de la tension piézoélectrique totale $V_p$. La tension piézoélectrique totale $V_p$ passe donc de -$V_{in}$-$V_{out}$ à -$V_{in}$+$V_{out}$. Seule la tension $V_{pb}$ a besoin d'être modifiée, et doit passer de -$V_{out}$ à +$V_{out}$, ce qu'elle fait naturellement avec l'augmentation de la tension piézoélectrique totale $V_p$, tandis que la tension $V_{pa}$ reste constante et fixée à -$V_{in}$ via le maintien des interrupteurs $K_5$ et $K_8$ fermés.

Durant la deuxième étape de cette première phase I, à charge sensiblement constante, seuls les interrupteurs $K_5$ et $K_a$ sont alors commandés en position fermée.

En l'instant temporel $t_1$, la tension $V_{pa}$ et la tension $V_{pb}$ sont donc déjà repositionnées sur les valeurs du palier de tension suivant, et la fermeture des interrupteurs $K_1$, $K_4$ s'effectue en mode ZVS. Si les interrupteurs $K_1$ et $K_4$ disposent d'une diode inverse intrinsèque ou d'une diode additionnelle placée en parallèle, leur mise en conduction peut se faire naturellement au regard du signe du courant. Les interrupteurs $K_5$, $K_8$ étaient déjà fermés.

A l'instant temporel $t_1$, les interrupteurs $K_1$ et $K_4$ se ferment ou deviennent passants.

**Configuration élévateur E3**

De l'instant temporel $t_0$ à l'instant temporel $t_1$, correspondant à la première phase I, le signe du courant $I_L$ conduit à une diminution de la tension piézoélectrique totale $V_p$. La tension piézoélectrique totale $V_p$ passe donc de la valeur $V_c$ égale à -$V_{in}$+$V_{out}$ à la valeur $V_b$ égale à $V_{in}$-$V_{out}$. Vu des ensembles piézoélectriques 12A, 12B, l'application de la valeur $V_b$ en l'instant temporel $t_1$ n'induit pas de variation de tension à ses bornes et de ce point de vue la fermeture des interrupteurs en l'instant temporel $t_1$ n'induit pas de pertes pour les ensembles piézoélectriques 12A, 12B.

Toutefois, la tension aux bornes des interrupteurs n'est pas nulle et leur fermeture induit des pertes propres à l'énergie stockée dans leurs capacités parasites, par exemple leur capacité parasite de sortie. En effet, la tension piézoélectrique totale $V_p$ initiale vaut - $V_{in}$+$V_{out}$, la tension $V_{pa}$ étant égale à -$V_{in}$ et la tension $V_{pb}$ étant égale à +$V_{out}$, et le signe du courant $I_L$ permet une diminution de la tension piézoélectrique totale $V_p$, contribuant à la diminution de la tension $V_{pb}$, mais pas à l'augmentation de la tension $V_{pa}$ qui doit passer de -$V_{in}$ à +$V_{in}$. Donc, en l'instant temporel $t_1$, la tension $V_{pa}$ est toujours à -$V_{in}$ tandis que la tension $V_{pb}$ égale à $V_p$ moins la tension $V_{pa}$ égale à ($V_{in}$-$V_{out}$)-(-$V_{in}$), soit $2V_{in}$-$V_{out}$.

Avant leur fermeture en l'instant temporel $t_1$, les interrupteurs $K_6$ et $K_7$ ont une différence de potentiel $V_{in}$ à leurs bornes, ce qui induit des pertes lors de leur fermeture. Avant leur fermeture en l'instant temporel $t_1$, les interrupteurs $K_2$ et $K_3$ ont une différence de potentiel ($V_{out}$ plus la tension $V_{pb}$)/2, soit ($V_{out}$+($2V_{in}$-$V_{out}$))/2 = $V_{in}$ à leurs bornes, ce qui induit des pertes lors de leur fermeture.

En pratique, si les interrupteurs $K_2$ et $K_3$ disposent d'une diode inverse (intrinsèque ou additionnel placée en parallèle), au regard du signe du courant $I_L$. Les interrupteurs $K_2$ et $K_3$ n'ont pas besoin d'être forcés à la fermeture, mais peuvent se fermer naturellement un peu plus tard. Dans ce cas, l'énergie stockée dans leur capacité de sortie sera dissipée dans les interrupteurs $K_6$ et $K_7$ à leur fermeture.

Au niveau du mode commun, si les interrupteurs $K_2$ et $K_3$ sont sensiblement identiques, et que les interrupteurs $K_6$ et $K_7$ sont sensiblement identiques, et que les interrupteurs $K_6$ et $K_7$ sont fermés sensiblement en même temps, (de même pour les interrupteurs $K_2$ et $K_3$ s'ils sont commandés à la fermeture de manière forcée), alors, de par la symétrie, le courant tiré sur le potentiel $V_{inp}$ s'oppose au courant tiré sur le potentiel $V_{inn}$, et de même pour le potentiel $V_{outp}$ et le potentiel $V_{outn}$, de sorte qu'il n'y a pas de courant de mode commun injecté sur la tension de sortie $V_{out}$.

Durant cette première phase I, à charge sensiblement constante, seuls les interrupteurs $K_5$ et $K_8$ sont alors passants ou commandés en position fermée. Durant cette première phase I, la tension piézoélectrique totale $V_p$ diminue, ce qui tend à faire diminuer les tensions $V_{pa}$ et $V_{pb}$, mais comme la tension $V_{pa}$ est déjà égale à la valeur $-V_{in}$ en l'instant temporel $t_0$, elle ne peut plus diminuer, ce qui fait passer un petit courant dans les interrupteurs $K_5$ et $K_8$, soit parce qu'ils sont fermés, soit via leur diodes inverses intrinsèques ou additionnelles.

De l'instant temporel $t_1$ à l'instant temporel $t_2$, correspondant à la deuxième phase II, les interrupteurs $K_2$, $K_3$, $K_6$ et $K_7$ sont passants ou fermés. La tension piézoélectrique totale $V_p$ est égale à $V_{in}-V_{out}$. Une puissance positive est tirée sur la tension d'entrée $V_{in}$ en même temps qu'une puissance positive est fournie à la tension de sortie $V_{out}$.

De l'instant temporel $t_a$ à l'instant temporel $t_3$, correspondant à la troisième phase III, le signe du courant $I_L$ conduit à une diminution de la tension piézoélectrique totale $V_p$. La tension piézoélectrique totale $V_p$ passe donc de $V_{in}-V_{out}$ à $-V_{in}-V_{out}$. Seule la tension $V_{pa}$ a besoin d'être modifiée, et doit passer de $+V_{in}$ à $-V_{in}$, ce qu'elle fait naturellement avec la diminution de la tension piézoélectrique totale $V_p$, tandis que la tension $V_{pb}$ reste constante et fixée à $-V_{out}$ via le maintien des interrupteurs $K_2$ et $K_3$ fermés ou passants.

Durant cette troisième phase III, à charge sensiblement constante, seuls les interrupteurs $K_2$ et $K_3$ sont alors passants ou commandés en position fermée.

En l'instant temporel $t_3$, la tension $V_{pa}$ et la tension $V_{pb}$ sont donc déjà repositionnées sur les valeurs du palier de tension suivant, et la fermeture des interrupteurs $K_5$, $K_8$ s'effectue en mode ZVS.

De l'instant temporel $t_3$ à l'instant temporel $t_4$, correspondant à la quatrième phase IV, les interrupteurs $K_2$, $K_3$, $K_5$ et $K_8$ sont passants ou fermés. La tension piézoélectrique totale $V_p$ est égale à $-V_{in}-V_{out}$. Une puissance positive est tirée sur la tension d'entrée $V_{in}$ en même temps qu'une puissance positive est aussi tirée sur la tension de sortie $V_{out}$.

De l'instant temporel $t_4$ à l'instant temporel $t_5$, correspondant à la cinquième phase V, le signe du courant $I_L$ conduit à une augmentation de la tension piézoélectrique totale $V_p$. La tension piézoélectrique totale $V_p$ passe donc de $-V_{in}-V_{out}$ à $-V_{in}+V_{out}$. Seule la tension $V_{pb}$ a besoin d'être modifiée, et doit passer de $-V_{out}$ à $+V_{out}$, ce qu'elle fait naturellement avec l'augmentation de la tension piézoélectrique totale $V_p$, tandis que la tension $V_{pa}$ reste constante et fixée à $-V_{in}$ via le maintien des interrupteurs $K_5$ et $K_8$ fermés.

Durant cette cinquième phase V, à charge sensiblement constante, seuls les interrupteurs $K_5$ et $K_8$ sont alors commandés en position fermée.

En l'instant temporel $t_5$, la tension $V_{pa}$ et la tension Vpb sont donc déjà repositionnées sur les valeurs du palier de tension suivant, et la fermeture des interrupteurs $K_1$, $K_4$ s'effectue en mode ZVS. Si les interrupteurs $K_1$ et $K_4$ disposent d'une diode inverse intrinsèque ou d'une diode additionnelle placée en parallèle, leur mise en conduction peut se faire naturellement au regard du signe du courant. Les interrupteurs $K_5$, $K_8$ étaient déjà fermés.

De l'instant temporel $t_5$ à l'instant temporel $t_6$ (ou l'instant temporel $t_0$), correspondant à la sixième phase VI, les interrupteurs $K_1$, $K_4$, $K_5$ et $K_8$ sont passants ou fermés. La tension piézoélectrique totale $V_p$ égale à $-V_{in}+V_{out}$. Une puissance positive est tirée sur la tension d'entrée $V_{in}$ en même temps qu'une puissance positive est fournie à la tension de sortie $V_{out}$.

## Configuration élévateur E4

La quatrième configuration élévateur E4 diffère de la troisième configuration élévateur E3, décrite précédemment, seulement en ce qu'elle intègre une excursion à $V_{ZVS}$ égale à $+V_{in}+V_{out}$ en l'instant temporel $t_0$. Cette excursion de tension permet de passer du palier de tension piézoélectrique totale $V_p$ égal à $-V_{in}+V_{out}$ au palier de tension piézoélectrique totale $V_p$ égal à $V_{in}-V_{out}$ en commutation ZVS au niveau des interrupteurs. Ce passage se fait en deux étapes, une première étape de l'instant temporel $t_{5b}$ à l'instant temporel $t_6$ (ou l'instant temporel $t_0$) pour passer de la tension piézoélectrique totale $V_p$ égale à $-V_{in}+V_{out}$ à la tension piézoélectrique totale $V_p$ égale à $+V_{in}+V_{out}$, puis une seconde étape de l'instant temporel $t_0$ à l'instant temporel $t_1$ pour passer de la tension piézoélectrique totale $V_p$ égale à $V_{in}+V_{out}$ à la tension piézoélectrique totale $V_p$ égale à $V_{in}+V_{out}$.

De l'instant temporel $t_{5b}$ à l'instant temporel $t_6$ (ou l'instant temporel $t_0$), le signe du courant $I_L$ conduit à une augmentation de la tension piézoélectrique totale $V_p$. La tension piézoélectrique totale $V_p$ passe donc de $-V_{in}+V_{out}$ à $V_{in}+V_{out}$. Seule la tension $V_{pa}$ a besoin d'être modifiée, et doit passer de $-V_{in}$ à $V_{in}$, ce qu'elle fait naturellement avec l'augmentation de la tension piézoélectrique totale $V_p$, tandis que la tension $V_{pb}$ reste constante et fixée à $V_{out}$ via le maintien des interrupteurs $K_1$ et $K_4$ passants (soit en maintenant une commande de fermeture, soit naturellement via leur diode inverse intrinsèque, soit encore via une diode parallèle additionnelle).

Durant la première étape de cette première phase I, à charge sensiblement constante, seuls les interrupteurs $K_1$ et $K_4$ sont alors commandés en position fermée.

En l'instant temporel $t_6$ (ou l'instant temporel $t_0$), la tension $V_{pa}$ et la tension $V_{pb}$ sont donc pré-positionnées sur respectivement $V_{in}$ et $V_{out}$, et la fermeture des interrupteurs $K_6$, $K_7$ s'effectue en mode ZVS. A l'instant temporel $t_0$, les interrupteurs $K_6$ et $K_7$ se ferment, tandis que les interrupteurs $K_1$ et $K_4$ s'ouvrent.

De l'instant temporel $t_0$ à l'instant temporel $t_1$, correspondant à la deuxième étape de la première phase I, le signe du courant $I_L$ conduit à une diminution de la tension piézoélectrique totale $V_p$. La tension piézoélectrique totale $V_p$ passe donc de $V_{in}+V_{out}$ à $V_{in}-V_{out}$. Seule la tension $V_{pb}$ a besoin d'être modifiée, et doit passer de $V_{out}$ à $-V_{out}$, ce qu'elle fait naturellement avec la diminution de la tension piézoélectrique totale $V_p$, tandis que la tension $V_{pa}$ reste constante et fixée à $+V_{in}$ via le maintien des interrupteurs $K_6$ et $K_7$ fermés.

Durant la deuxième étape de cette première phase I, à charge sensiblement constante, seuls les interrupteurs $K_6$ et $K_7$ sont alors commandés en position fermée.

En l'instant temporel $t_1$, la tension $V_{pa}$ et la tension $V_{pb}$ sont donc déjà repositionnées sur les valeurs du palier de tension suivant, et la fermeture des interrupteurs $K_2$, $K_3$ s'effectue en mode ZVS. Si les interrupteurs $K_2$ et $K_3$ disposent d'une diode inverse intrinsèque ou d'une diode additionnelle placée en parallèle, leur mise en conduction peut se faire naturellement au regard du signe du courant. Les interrupteurs $K_6$, $K_7$ étaient déjà fermés. A l'instant temporel $t_1$, les interrupteurs $K_2$ et $K_3$ se ferment ou deviennent passants.

L'homme du métier observera que pour les première et deuxième configurations élévateur E1 et E2 de la figure 3, les interrupteurs $K_2$ et $K_3$ peuvent être de simples diodes qui s'ouvrent et se ferment naturellement. De manière analogue, pour les troisième et quatrième configurations élévateur E3 et E4 de la figure 3, les interrupteurs $K_1$ et $K_4$ peuvent être de simples diodes qui s'ouvrent et se ferment naturellement.

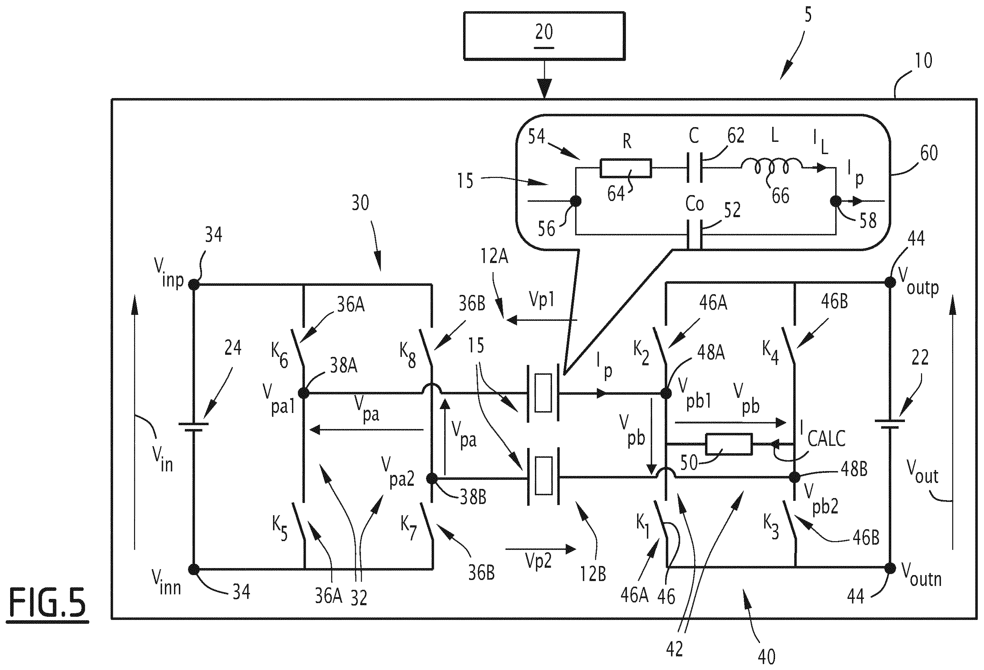

En complément facultatif, dans les exemples des figures 5 à 9, le convertisseur 10 comprend en outre au moins un circuit d'aide à la commutation 50, chaque circuit d'aide à la commutation 50 étant connecté à un point milieu respectif parmi les premier(s) 38 et deuxième(s) 48 points milieux, chaque circuit d'aide à la commutation 50 étant configuré pour, via la circulation d'un courant préalablement reçu, décharger une capacité parasite d'au moins un interrupteur 36, 46 du pont de commutation 30, 40 respectif auquel il est connecté, et respectivement charger au moins une capacité parasite d'un autre interrupteur 36, 46 dudit pont de commutation 30, 40.

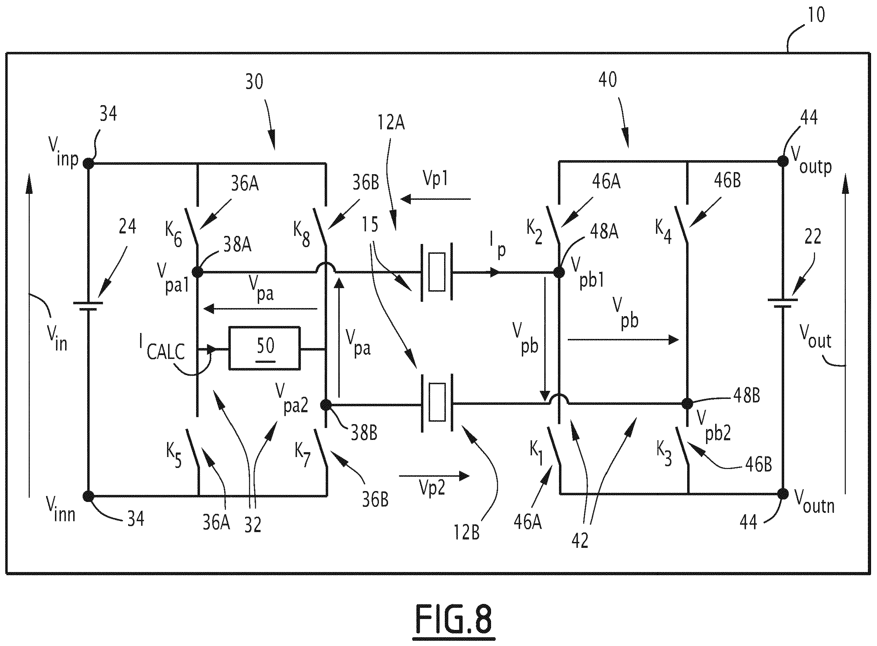

Dans les exemples des figures 5 et 8, le convertisseur 10 comprend un unique circuit d'aide à la commutation 50 connecté au premier pont de commutation 30 ou bien au deuxième pont de commutation 40. Dans l'exemple de la figure 5, l'unique circuit d'aide à la commutation 50 est connecté au deuxième pont de commutation 40. Dans l'exemple de la figure 8, l'unique circuit d'aide à la commutation 50 est connecté au premier pont de commutation 30.

Dans les exemples des figures 5 et 8, le deuxième pont de commutation 40 comporte deux deuxièmes branches de commutation 42, respectivement le premier pont de commutation 30 comporte deux premières branches de commutation 32 ; et le circuit d'aide à la commutation 50 est alors connecté entre les points milieux respectifs 38, 48 des deux branches de commutation 32, 42 dudit pont 30, 40. Dans l'exemple de la figure 5, le circuit d'aide à la commutation 50 est alors connecté entre les deuxièmes points milieux 48 des deux deuxièmes branches de commutation 42 du deuxième pont de commutation 40. De manière analogue, dans l'exemple de la figure 8, le circuit d'aide à la commutation 50 est alors connecté entre les premiers points milieux 38 des deux premières branches de commutation 32 du premier pont de commutation 30.

En variante, non représentée, le convertisseur 10 comprend deux circuits d'aide à la commutation 50, un premier circuit d'aide à la commutation étant connecté au premier pont de commutation 30 et un deuxième circuit d'aide à la commutation étant connecté au deuxième pont de commutation 40.

Selon cette variante, l'homme du métier comprendra que chaque circuit d'aide à la commutation 50 est susceptible d'être connecté entre les points milieux respectifs 38, 48 des deux branches de commutation 32, 42.

Chaque circuit d'aide à la commutation 50 est configuré, via la circulation d'un courant $I_{CALC}$ préalablement reçu, pour décharger au moins une capacité parasite d'un interrupteur 36, 46, de préférence un interrupteur à fermer, du pont de commutation 30, 40 respectif auquel il est connecté ; respectivement pour charger au moins une capacité parasite d'un autre interrupteur 36, 46, de préférence un interrupteur à ouvrir ou à maintenir ouvert, dudit pont de commutation 30, 40.

Chacun des interrupteurs dudit pont de commutation 30 est ouvert lors de la circulation, par le circuit d'aide à la commutation 50, du courant préalablement reçu.

Suite à cette circulation de courant, le/les interrupteur(s) 36, 46 dont la capacité parasite a été déchargée par le circuit d'aide à la commutation 50 est/sont fermés. Le/les autre(s) interrupteur(s) 36, 46 dont la capacité parasite a été chargée par le circuit d'aide à la commutation 50 reste ouvert.

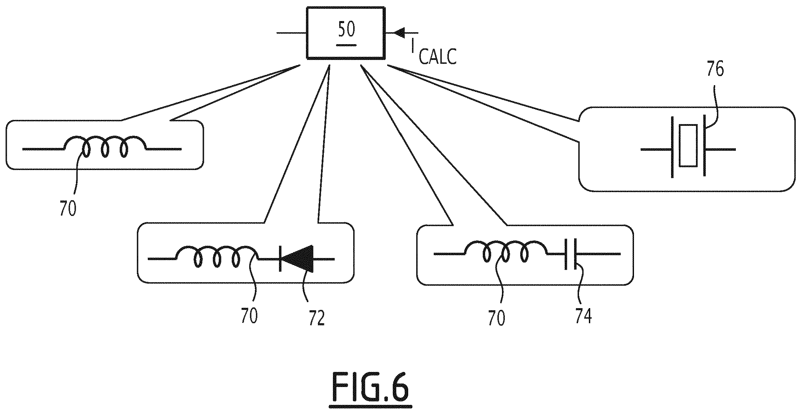

Chaque circuit d'aide à la commutation 50 comporte par exemple une inductance 70 ; ou un premier ensemble formé de l'inductance 70 et d'une diode 72 connectées en série ; ou un deuxième ensemble formé de l'inductance 70 et d'un condensateur 74 connectés en série ; ou encore un élément piézoélectrique additionnel 76, comme représenté sur la figure 6.

Chaque circuit d'aide à la commutation 50 est par exemple une inductance 70, l'inductance 70 étant de préférence constituée d'une bobine et d'un circuit magnétique. En variante, chaque circuit d'aide à la commutation 50 est en forme du premier ensemble de l'inductance 70 et de la diode 72 connectées en série, et de préférence constitué dudit premier ensemble de l'inductance 70 et de la diode 72. En variante encore, chaque circuit d'aide à la commutation 50 est en forme du deuxième ensemble de l'inductance 70 et du condensateur 74 connectés en série, et de préférence constitué dudit deuxième ensemble de l'inductance 70 et du condensateur 74. En variante encore, chaque circuit d'aide à la commutation 50 est en forme de l'élément piézoélectrique additionnel 76, et de préférence constitué de l'élément piézoélectrique additionnel 76.

Dans l'exemple de réalisation où le circuit d'aide à la commutation 50 est en forme de l'inductance 70 seule, l'inductance 70 voit son courant croitre sur une demi-période, i.e. lorsque la tension à ses bornes est positive ; puis son courant décroitre sur l'autre demi-période, i.e. lorsque la tension à ses bornes est négative. Cet exemple de réalisation du circuit d'aide à la commutation 50 nécessite de préférence que la tension aux bornes de l'inductance 70 soit de moyenne sensiblement nulle, au risque sinon d'avoir une dérive en courant. Si le circuit d'aide à la commutation 50 est connecté au deuxième pont 40, en particulier entre les deuxièmes points milieux 48, la tension aux bornes de l'inductance 70 est la tension $V_{pb}$. Corollairement, si le circuit d'aide à la commutation 50 est connecté au premier pont 30, en particulier entre les premiers points milieux 38, la tension aux bornes de l'inductance 70 est la tension $V_{pa}$.

La variante où le circuit d'aide à la commutation 50 est en forme de l'inductance 70 et de la diode 72 connectées en série, permet de charger l'inductance 70 uniquement sur une demi-période avec la bonne polarité, en particulier pour des cycles où le courant $I_{CALC}$ est reçu au cours d'une période temporelle avec une seule polarité, par exemple entre les instants temporels $t_2$ et $t_3$ pour les cycles abaisseurs A1_C et A3_C décrits par la suite (polarité positive du courant $I_{CALC}$ pour le cycle abaisseur A1_C entre les instants temporels $t_2$ et $t_3$, polarité négative pour le cycle abaisseur A3_C entre ces instants temporels $t_2$ et $t_3$). En particulier, la diode 72 permet alors d'éviter de charger l'inductance 70 avec un courant inverse entre les instants temporels t3 et T. Ce fonctionnement unidirectionnel en courant permet aussi de réduire le courant efficace vu par l'inductance 70 et donc les pertes. Par ailleurs, le circuit d'aide à la commutation 50 selon cette variante n'est pas sensible à la présence d'une composante continue à partir du moment où la composante continue est dans le sens d'un blocage de la diode 72.

La variante où le circuit d'aide à la commutation 50 est en forme de l'inductance 70 et du condensateur 74 connectés en série, permet - par rapport à l'exemple de l'inductance 70 seule - de réduire, voire éliminer une composante continue éventuelle. Néanmoins, le condensateur 74 peut être assez volumineux. En effet, la tension aux bornes du condensateur 74 doit évoluer peu, i.e. dans une faible proportion, par rapport à la tension d'entrée $V_{in}$ ou à la tension de sortie $V_{out}$, par exemple avoir une amplitude inférieure à 50% de la tension d'entrée $V_{in}$ ou de sortie $V_{out}$.

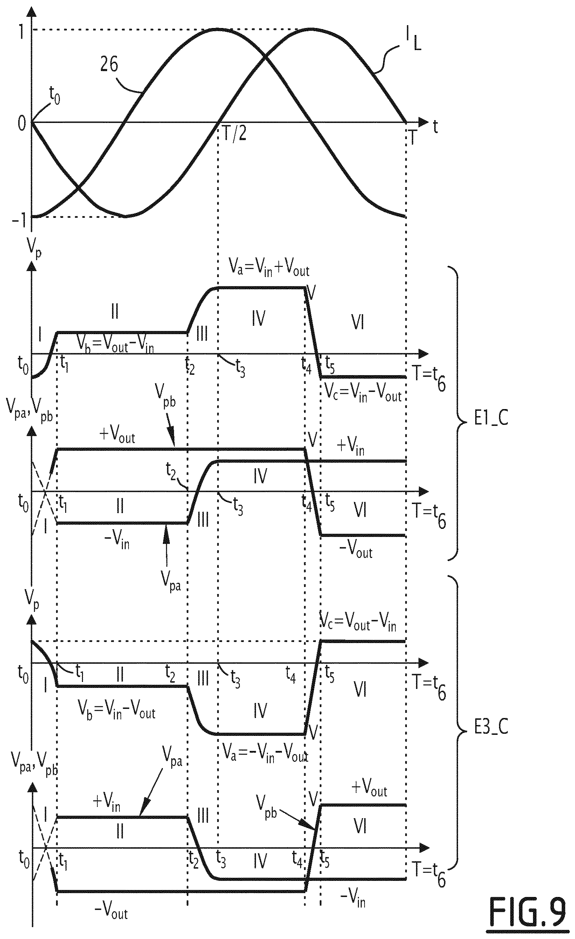

Selon la variante où le circuit d'aide à la commutation 50 est en forme de l'élément piézoélectrique additionnel 76, à partir du moment où le pilotage du convertisseur 10 s'effectue entre la fréquence de résonance et d'antirésonance de l'élément piézoélectrique additionnel 76, ce dernier se met à osciller et à produire un courant $I_{CALC}$ sensiblement en quadrature avec la tension à ses bornes, telle que la tension $V_{pb}$ si l'élément piézoélectrique additionnel 76 est connecté au deuxième pont 40 entre les deuxièmes points milieux 48, ou encore la tension $V_{pa}$ si l'élément piézoélectrique additionnel 76 est connecté au premier pont 30 entre les premiers points milieux 38. Le courant $I_{CALC}$ passe alors par un extrema autour de l'instant temporel t3 pour les cycles abaisseurs A1_C et A3_C, ce qui permet d'assurer la fonction d'inversion de la tension $V_{pb}$ entre les instants temporels $t_2$ et $t_3$ ; ou similairement autour de l'instant temporel $t_0$ pour les cycles élévateurs E1_C et E3_C décrits par la suite en regard de la figure 9, ce qui permet d'assurer la fonction d'inversion de la tension $V_{pa}$ entre les instants temporels $t_0$ et $t_1$.

L'élément piézoélectrique additionnel 76 est typiquement au moins 3 fois plus petit que le ou les éléments piézoélectriques 15 du convertisseur 10, l'élément piézoélectrique additionnel 76 n'ayant qu'à charger/décharger les capacités parasites des interrupteurs 36, 46. La capacité parasite des interrupteurs 36, 46 est en effet considérée comme étant au moins trois fois inférieure à la capacité de référence $C_0$ du ou des éléments piézoélectriques 15 du convertisseur 10. Cette variante où le circuit d'aide à la commutation 50 est en forme de l'élément piézoélectrique additionnel 76 est insensible à une éventuelle composante continue (quelle que soit sa polarité), et le circuit d'aide à la commutation 50 est apte à être connecté aussi bien au premier pont 30 (tension $V_{pa}$) qu'au deuxième pont 40 (tension $V_{pb}$).

Autrement dit, la capacité de référence de l'élément piézoélectrique additionnel 76 est au moins trois fois inférieure à la capacité de référence $C_0$ de chaque ensemble piézoélectrique 12 connecté entre des premier 38 et deuxième 48 points milieux respectifs.

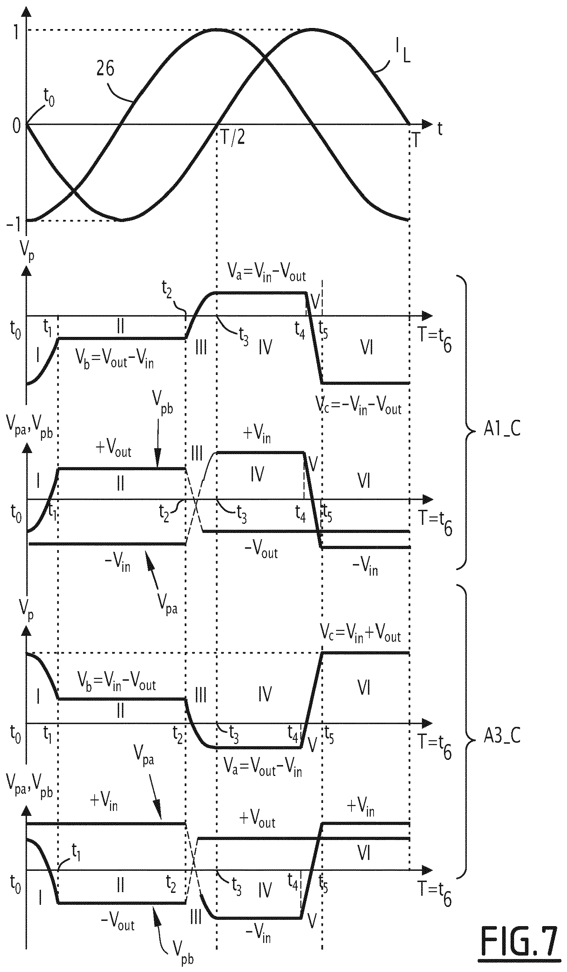

Le fonctionnement du convertisseur 10 dans l'exemple de la figure 5 va désormais être expliqué selon deux configurations abaisseur de tension, à savoir une première configuration abaisseur A1_C et une deuxième configuration abaisseur A3_C en regard de la figure 7. La différence résultant du circuit d'aide à la commutation 50 selon l'aspect complémentaire porte sur les évolutions des tensions $V_{pa}$ et $V_{pb}$ entre les instants temporels $t_2$ et $t_3$ dans le cas de ces configurations abaisseur A1_C, A3_C, et plus particulièrement sur les zones représentées en trait pointillé sur la figure 7, ceci pour marquer la différence.

Le cycle de conversion du convertisseur 10 selon l'aspect complémentaire est décrit ci-après pour les première A1_C et deuxième A3_C configurations abaisseur, en se focalisant sur les différences par rapport au cycle de conversion du convertisseur 10 de la figure 1 pour les mêmes configurations abaisseur A1 et A3.

Pour la première configuration abaisseur A1_C, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ augmenter, ceci sous la tension $V_{pb}$ égale à +Vout. En l'instant temporel $t_2$, le courant $I_{CALC}$ est positif.

Juste avant l'instant temporel $t_2$, la tension piézoélectrique totale $V_p$ est égale à - $V_{in}$+$V_{out}$, la tension $V_{pa}$ étant égale à -$Vi_n$, et la tension $V_{pb}$ étant égale à +$V_{out}$ ; et les interrupteurs $K_5$, $K_8$, $K_1$, $K_4$ sont fermés.

En l'instant temporel $t_2$, tous les interrupteurs qui étaient fermés s'ouvrent. Le courant $I_{CALC}$ charge alors les capacités parasites des interrupteurs $K_1$, $K_4$, pendant qu'il décharge les capacités parasites des interrupteurs $K_2$ et $K_3$. De même, au travers des ensembles piézoélectriques 12 dont la tension évolue lentement, le courant $I_{CALC}$ charge partiellement les capacités parasites des interrupteurs $K_5$, $K_8$, pendant qu'il décharge partiellement les capacités parasites des interrupteurs $K_6$, $K_7$. La tension $V_{pb}$ évolue ainsi de +$V_{out}$ à -$V_{out}$, tandis que la tension $V_{pa}$ évolue sensiblement de -$V_{in}$ à -$V_{in}$+2$V_{out}$ plus l'évolution de la tension piézoélectrique totale $V_p$ depuis l'instant temporel $t_2$.

L'inversion de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur maximale en l'instant temporel $t_3$, alors que le courant interne $I_L$ se rapproche de 0 en ledit instant temporel $t_3$.

Une fois l'inversion complète de la tension $V_{pb}$ atteinte (passage de $V_{out}$ à -$V_{out}$), alors les interrupteurs $K_2$ et $K_3$ sont fermés de sorte à figer la tension $V_{pb}$, tandis que la tension $V_{pa}$ continue sa progression jusqu'à $V_{in}$ sous l'effet de l'augmentation naturelle de la tension piézoélectrique totale $V_p$.

En l'instant temporel $t_3$, les interrupteurs $K_6$ et $K_7$ sont fermés. Les interrupteurs $K_2$ et $K_3$ sont également fermés si cela n'avait pas été déjà fait avant, i.e. si la tension $V_{pb}$ n'avait pas encore atteint -$V_{out}$.

En complément, si les interrupteurs $K_2$ et $K_3$ comportent une diode inverse intrinsèque ou une diode additionnelle placée en parallèle, leur mise en conduction peut se faire naturellement au regard du signe du courant interne $I_L$ après l'instant temporel $t_3$, ou au regard du courant $I_{CALC}$ résiduel avant l'instant temporel $t_3$.

Le reste du cycle de conversion du convertisseur 10 selon l'aspect complémentaire reste sensiblement inchangé par rapport au cycle de conversion du convertisseur 10 de la figure 1.

L'excursion en tension de la tension piézoélectrique totale $V_p$ est ainsi limitée entre les instants temporels $t_2$ et $t_4$, celle-ci allant de -$V_{in}$+$V_{out}$ à $V_{in}$-$V_{out}$, au lieu d'aller de -$V_{in}$+$V_{out}$ à +$V_{in}$+$V_{out}$ avec le convertisseur 10 de la figure 1 (dans le cas de la configuration abaisseur A2 pour assurer des commutations des interrupteurs 36, 46 à zéro de tension), soit une excursion de 2$V_{in}$-2$V_{out}$ au lieu de 2$V_{in}$, tout en assurant des commutations des interrupteurs 36, 46 à zéro de tension.

Pour la deuxième configuration abaisseur A3_C, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pb}$ égale à -$V_{out}$. En l'instant temporel $t_2$, le courant $I_{CALC}$ est négatif.

Juste avant l'instant temporel $t_2$, la tension piézoélectrique totale $V_p$ est égale à $V_{in}$-$V_{out}$, la tension $V_{pa}$ étant égale à $V_{in}$, et la tension $V_{pb}$ étant égale à -$V_{out}$ ; et les interrupteurs $K_6$, $K_7$, $K_2$, $K_3$ sont fermés.

En l'instant temporel $t_2$, tous les interrupteurs qui étaient fermés s'ouvrent. Le courant $I_{CALC}$ charge alors les capacités parasites des interrupteurs $K_2$, $K_3$, pendant qu'il décharge les capacités parasites des interrupteurs $K_1$ et $K_4$. De même, au travers des ensembles piézoélectriques 12 dont la tension évolue lentement, le courant $I_{CALC}$ charge partiellement les capacités parasites des interrupteurs $K_6$, $K_7$, pendant qu'il décharge partiellement les capacités parasites des interrupteurs $K_5$, $K_8$. La tension $V_{pb}$ évolue ainsi de -$V_{out}$ à +$V_{out}$, tandis que la tension $V_{pa}$ évolue sensiblement de +$V_{in}$ à +$V_{in}$-2$V_{out}$ plus l'évolution de la tension piézoélectrique totale $V_p$ depuis l'instant temporel $t_2$.

L'inversion de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur minimale (son extremum négatif) en l'instant temporel $t_3$, alors que le courant interne $I_L$ se rapproche de 0 en ledit instant temporel $t_3$.

Une fois l'inversion complète de la tension $V_{pb}$ atteinte (passage de -$V_{out}$ à +$V_{out}$), alors les interrupteurs $K_1$ et $K_4$ sont fermés de sorte à figer la tension $V_{pb}$, tandis que la tension $V_{pa}$ continue sa progression jusqu'à -$V_{in}$ sous l'effet de la diminution naturelle de la tension piézoélectrique totale $V_p$.

En l'instant temporel $t_3$, les interrupteurs $K_5$ et $K_8$ sont fermés. Les interrupteurs $K_1$ et $K_4$ sont également fermés si cela n'avait pas été déjà fait avant, i.e. si la tension $V_{pb}$ n'avait pas encore atteint +$V_{out}$.

En complément, si les interrupteurs $K_1$ et $K_4$ comportent une diode inverse intrinsèque ou une diode additionnelle placée en parallèle, leur mise en conduction peut se faire naturellement au regard du signe du courant interne $I_L$ après

l'instant temporel $t_3$, ou au regard du courant $I_{CALC}$ résiduel avant l'instant temporel $t_3$.

Le reste du cycle de conversion du convertisseur 10 de la figure 5 reste sensiblement inchangé par rapport au cycle de conversion du convertisseur 10 de la figure 1.

Là encore, l'excursion en tension de la tension piézoélectrique totale $V_p$ est ainsi limitée entre les instants temporels $t_2$ et $t_4$, celle-ci allant de $V_{in}-V_{out}$ à $V_{out}-V_{in}$, au lieu d'aller de $V_{in}-V_{out}$ à $-V_{in}-V_{out}$ avec le convertisseur 10 de la figure 1 (dans le cas de la configuration abaisseur A4 pour assurer des commutations des interrupteurs 36, 46 à zéro de tension), soit une excursion de de $2V_{in}-2V_{out}$ au lieu de $2V_{in}$, tout en assurant des commutations des interrupteurs 36, 46 à zéro de tension.

Les figures 8 et 9 illustrent une variante de réalisation du convertisseur 10 pour lequel le circuit d'aide à la commutation 50 est connecté au premier pont de commutation 30, par exemple entre les premiers points milieux 38 des deux premières branches de commutation 32.

Selon cette variante de réalisation du convertisseur 10, la différence par rapport à l'exemple de réalisation des figures 5 et 7, décrit précédemment, est que le circuit d'aide à la commutation 50 est alors connecté au premier pont de commutation 30 au lieu d'être connecté au deuxième pont de commutation 40 selon l'exemple de réalisation des figures 5 et 7. Les autres éléments qui sont inchangés entre l'exemple de réalisation des figures 5 et 7, et cette variante des figures 8 et 9 sont repris avec des références identiques.

Le fonctionnement du convertisseur 10 dans l'exemple de la figure 8 va désormais être expliqué selon deux configurations élévateur de tension, à savoir une première configuration élévateur E1_C et une deuxième configuration élévateur E3_C en regard de la figure 9. La différence résultant du circuit d'aide à la commutation 50 selon cet aspect complémentaire porte sur les évolutions des tensions $V_{pa}$ et $V_{pb}$ entre les instants temporels $t_0$ et $t_1$ dans le cas de ces configurations élévateur E1_C, E3_C, et plus particulièrement sur les zones représentées en trait pointillé sur la figure 9, ceci pour marquer la différence.

Le cycle de conversion du convertisseur 10 selon cet aspect complémentaire est décrit ci-après pour les première E1_C et deuxième E3_C configurations élévateur, en se focalisant sur les différences par rapport au cycle de conversion du convertisseur 10 de la figure 1 pour les mêmes configurations élévateur.

Pour les configurations abaisseur A1_C et A3_C, décrites précédemment, c'était la tension $V_{pb}$ qui avait une polarité homogène sur chacune des deux demi-périodes avec une inversion de polarité entre les deux demi-périodes, et il était alors préférable de disposer le circuit d'aide à la commutation 50 du côté de la tension $V_{pb}$, i.e. connecté au deuxième pont de commutation 40, entre les deuxièmes points milieux 48 respectifs.

Cette fois-ci, pour ces configurations élévateur E1_C et E3_C, c'est la tension $V_{pa}$ qui a une polarité homogène sur chacune des deux demi-périodes avec une inversion de polarité entre les deux demi-périodes (même polarité sur les paliers $V_a$ et $V_c$ et polarité opposée sur le palier $V_b$). Pour ces configurations élévateur E1_C et E3_C, il est donc préférable de disposer le circuit d'aide à la commutation 50 du côté de la tension $V_{pa}$, i.e. connecté au premier pont de commutation 30, entre les premiers points milieux 38 respectifs. Cet agencement du circuit d'aide à la commutation 50 du côté de la tension $V_{pa}$ est préférable sauf dans le cas où le circuit d'aide à la commutation 50 est en forme de l'inductance 70 et de la diode 72 connectées en série, où l'agencement du côté de la tension $V_{pb}$ (i.e. connecté au deuxième pont de commutation 40, entre les deuxièmes points milieux 48 respectifs) reste préférable pour que la composante continue éventuelle ne rende pas la diode 72 passante.

Pour la première configuration élévateur E1_C, entre les instants temporels $t_3$ et T (ou $t_0$), selon l'exemple de réalisation du circuit d'aide à la commutation 50, l'inductance 70 ou bien l'élément piézoélectrique additionnel 76 voit son courant $I_{CALC}$ augmenter, ceci sous la tension $V_{pa}$ égale à $+V_{in}$. En l'instant temporel T (ou $t_0$), le courant $I_{CALC}$ est positif.

Juste avant l'instant temporel $t_0$, la tension piézoélectrique totale $V_p$ est égale à $Vi_n-V_{out}$, la tension $V_{pa}$ étant égale à $V_{in}$, et la tension $V_{pb}$ étant égale à $-V_{out}$ ; et les interrupteurs $K_6$, $K_7$, $K_2$, $K_3$ sont fermés.

En l'instant temporel $t_0$, tous les interrupteurs qui étaient fermé s'ouvrent. Le courant $I_{CALC}$ charge alors les capacités parasites des interrupteurs $K_6$, $K_7$, pendant qu'il décharge les capacités parasites des interrupteurs $K_5$, $K_8$. De même, au travers des ensembles piézoélectriques 12A, 12B, dont la tension évolue lentement, le courant $I_{CALC}$ charge partiellement les capacités parasites des interrupteurs $K_2$, $K_3$, pendant qu'il décharge partiellement les capacités parasites des interrupteurs $K_1$, $K_4$. La tension $V_{pa}$ évolue ainsi de $+V_{in}$ à $-Vi_n$, tandis que la tension $V_{pb}$ évolue sensiblement de $-V_{out}$ à $-V_{out}+2V_{in}$ plus l'évolution de la tension piézoélectrique totale $V_p$ depuis l'instant temporel $t_0$.

L'inversion de tension $V_{pa}$ est considérée achevée avant que la tension piézoélectrique totale $V_p$ atteigne le palier $V_b$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur maximale en l'instant temporel $t_0$, alors que le courant interne $I_L$ se rapproche de 0 en ledit instant temporel $t_0$.

Une fois l'inversion complète de la tension $V_{pa}$ atteinte (passage de $V_{in}$ à $-V_{in}$), alors les interrupteurs $K_5$ et $K_8$ sont fermés de sorte à figer la tension $V_{pa}$, tandis que la tension $V_{pb}$ continue sa progression jusqu'à $V_{out}$ sous l'effet de l'augmentation naturelle de la tension piézoélectrique totale $V_p$.

En l'instant temporel $t_1$, les interrupteurs $K_1$ et $K_4$ sont fermés. Les interrupteurs $K_5$ et $K_8$ sont également fermés si cela n'avait pas été déjà fait avant, i.e. si la tension $V_{pa}$ n'avait pas encore atteint $-V_{in}$.

En complément, si les interrupteurs $K_1$ et $K_4$ comportent une diode inverse intrinsèque ou une diode additionnelle placée en parallèle, leur mise en conduction peut se faire naturellement au regard du signe du courant interne $I_L$ après l'instant temporel $t_0$.

Le reste du cycle de conversion du convertisseur 10 selon cet aspect complémentaire reste sensiblement inchangé par rapport au cycle de conversion du convertisseur 10 de la figure 1.

L'excursion en tension de la tension piézoélectrique totale $V_p$ est ainsi limitée entre les instants temporels $t_5$ et $t_1$, celle-ci allant de $V_{in}-V_{out}$ à $V_{out}-V_{in}$, au lieu d'aller de $-V_{in}-V_{out}$ à $V_{out}-V_{in}$ avec le convertisseur 10 de la figure 1 (dans le cas de la configuration élévateur E2 pour assurer des commutations des interrupteurs 36, 46 à zéro de tension), soit une excursion de $2V_{out}-2V_{in}$ au lieu de $2V_{out}$, tout en assurant des commutations des interrupteurs 36, 46 à zéro de tension.

Pour la deuxième configuration élévateur E3_C, entre les instants temporels $t_3$ et T (ou $t_0$), selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pa}$ égale à $-V_{in}$. En l'instant temporel T (ou $t_0$), le courant $I_{CALC}$ est négatif.

Juste avant l'instant temporel $t_0$, la tension piézoélectrique totale $V_p$ est égale à $-V_{in}+V_{out}$, la tension $V_{pa}$ étant égale à $-Vi_n$, et la tension $V_{pb}$ étant égale à $+V_{out}$ ; et les interrupteurs $K_5$, $K_8$, $K_1$, $K_4$ sont fermés.

En l'instant temporel $t_0$, tous les interrupteurs qui étaient fermés s'ouvrent. Le courant $I_{CALC}$ charge alors les capacités parasites des interrupteurs $K_5$, $K_8$, pendant qu'il décharge les capacités parasites des interrupteurs $K_6$, $K_7$. De même, au travers des ensembles piézoélectriques 12 dont la tension évolue lentement, le courant $I_{CALC}$ charge partiellement les capacités parasites des interrupteurs $K_1$, $K_4$, pendant qu'il décharge partiellement les capacités parasites des interrupteurs $K_2$, $K_3$. La tension $V_{pa}$ évolue ainsi de $-V_{in}$ à $+V_{in}$, tandis que la tension $V_{pb}$ évolue sensiblement de $V_{out}$ à $V_{out}-2V_{in}$ plus l'évolution de la tension piézoélectrique totale $V_p$ depuis l'instant temporel $t_0$.

L'inversion de tension $V_{pa}$ est considérée achevée avant que la tension piézoélectrique totale $V_p$ atteigne le palier $V_b$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur minimale (son extremum négatif) en l'instant temporel $t_0$, alors que le courant interne $I_L$ se rapproche de 0 en ledit instant temporel $t_0$.

Une fois l'inversion complète de la tension $V_{pa}$ atteinte (passage de $-V_{in}$ à $+V_{in}$), alors les interrupteurs $K_6$ et $K_7$ sont fermés de sorte à figer la tension $V_{pa}$, tandis que la tension $V_{pb}$ continue sa progression jusqu'à $-V_{out}$ sous l'effet de la diminution naturelle de la tension piézoélectrique totale $V_p$.

En l'instant temporel $t_1$, les interrupteurs $K_2$ et $K_3$ sont fermés. Les interrupteurs $K_6$ et $K_7$ sont également fermés si cela n'avait pas été déjà fait avant, i.e. si la tension $V_{pa}$ n'avait pas encore atteint $+V_{in}$.

En complément, si les interrupteurs $K_2$ et $K_3$ comportent une diode inverse intrinsèque ou une diode additionnelle placée en parallèle, leur mise en conduction peut se faire naturellement au regard du signe du courant interne $I_L$ après l'instant temporel $t_0$.

Le reste du cycle de conversion du convertisseur 10 selon cet aspect complémentaire reste sensiblement inchangé par rapport au cycle de conversion du convertisseur 10 de la figure 1.

Là aussi, l'excursion en tension de la tension piézoélectrique totale $V_p$ est ainsi limitée entre les instants temporels $t_5$ et $t_1$, celle-ci allant de $V_{out}-V_{in}$ à $V_{in}-V_{out}$, au lieu d'aller de $+V_{in}+V_{out}$ à $V_{in}-V_{out}$ avec le convertisseur 10 de la figure 1 (dans le cas de la configuration élévateur E4 pour assurer des commutations des interrupteurs 36, 46 à zéro de tension), soit une excursion de $2V_{out}-2V_{in}$ au lieu de $2V_{out}$, tout en assurant des commutations des interrupteurs 36, 46 à zéro de tension.

En complément facultatif, lorsque le convertisseur 10 comprend deux circuits d'aide à la commutation 50, avec le premier circuit d'aide à la commutation connecté au premier pont de commutation 30 et le deuxième circuit d'aide à la commutation connecté au deuxième pont de commutation 40, les circuits d'aide à la commutation 50 étant alors agencés à la fois du côté de la tension $V_{pa}$ et du côté de la tension $V_{pb}$, les effets des deux circuits d'aide à la commutation 50 s'additionnent. Il faut juste choisir les circuit d'aide à la commutation 50 en fonction de la présence ou non d'une composante continue, et éventuellement selon le signe de cette composante continue s'il y en a une.

En variante, les interrupteurs $K_1$, $K_2$, $K_3$ et $K_4$ sont de simple diodes, et les interrupteurs $K_5$, $K_6$, $K_7$ et $K_8$ sont des interrupteurs monodirectionnels en tension.

On conçoit ainsi que le convertisseur d'énergie électrique 10 selon cet aspect complémentaire offre un pilotage encore davantage amélioré de par le circuit d'aide à la commutation 50.

**Revendications**

1. Dispositif électronique (20) de pilotage d'un convertisseur d'énergie électrique (10) apte à convertir une tension d'entrée ($V_{in}$) en au moins une tension de sortie ($V_{out}$), le convertisseur (10) comportant un premier pont de commutation (30) comportant deux premières branches de commutation (32), chaque première branche de commutation (32) étant connectée entre deux bornes (34) d'application de la tension d'entrée ($V_{in}$) et comportant au moins deux premiers interrupteurs (36) connectés en série et reliés entre eux en un premier point milieu (38) ; au moins un deuxième pont de commutation (40) comportant deux deuxièmes branches de commutation (42), chaque deuxième branche de commutation (42) étant connectée entre deux bornes (44) de fourniture de la tension de sortie ($V_{out}$) et comportant au moins deux deuxièmes interrupteurs (46) connectés en série et reliés entre eux en un deuxième point milieu (48) ; au moins un couple de premier (12A) et deuxième (12B) ensembles piézoélectriques, chaque ensemble piézoélectrique (12A, 12B) comportant au moins un élément piézoélectrique (15) et étant connecté entre des premier (38) et deuxième (48) points milieux respectifs, les points milieux (38, 48) entre lesquels sont connectés les ensembles piézoélectriques (12A,12B) étant distincts d'un ensemble piézoélectrique (12A) à l'autre (12B) ;

   le dispositif électronique de pilotage (20) est configuré pour commander, lors d'un cycle respectif de résonance des ensembles piézoélectriques (12A,12B), une commutation de chacun des interrupteurs (36, 46) pour alterner des phases (II, IV, VI) à tension sensiblement constante aux bornes des ensembles piézoélectriques (12A,12B) et des phases (I, III, V) à charge sensiblement constante aux bornes desdits ensembles piézoélectriques (12A, 12B) ; par tension sensiblement constante, on entend une variation de tension inférieure à 20% de la tension d'entrée ou de sortie du convertisseur (10) ; et par charge sensiblement constante, on entend un échange d'une charge avec l'extérieur qui est inférieur à 10% de la charge qui aurait été échangée avec l'extérieur si la tension avait été maintenue constante ;

   **caractérisé en ce que** le dispositif électronique de pilotage (20) est configuré pour, lors de chaque phase (I, III, V) à charge sensiblement constante, commander en position fermée en même temps au plus un interrupteur respectif parmi les interrupteurs (36A, 46A) connectés directement au premier ensemble piézoélectrique (12A) et au plus un interrupteur respectif parmi les interrupteurs (36B, 46B) connectés directement au deuxième ensemble piézoélectrique (12B), et en position ouverte tous les autres interrupteurs (36, 46) des premières et deuxièmes branches de commutation (32, 42).

2. Dispositif (20) selon la revendication 1, dans lequel la valeur ($V_a$, $V_b$, $V_c$) de la tension de chacune des phases (II, IV, VI) à tension sensiblement constante est distincte de la valeur nulle.

3. Dispositif (20) selon la revendication 2, dans lequel la valeur ($V_a$, $V_b$, $V_c$) de la tension de chacune des phases (II, IV, VI) à tension sensiblement constante est choisie parmi le groupe consistant en : différence ($V_{in}$ - $V_{out}$) entre la valeur de la tension d'entrée ($V_{in}$) et celle de la tension de sortie ($V_{out}$) ; différence ($V_{out}$ - $V_{in}$) entre la valeur de la tension de sortie ($V_{out}$) et celle de la tension d'entrée ($V_{in}$) ; somme ($V_{in}$ + $V_{out}$) des valeurs des tensions d'entrée ($V_{in}$) et de sortie ($V_{out}$) ; et opposé de la somme (-$V_{in}$ -$V_{out}$) des valeurs des tensions d'entrée ($V_{in}$) et de sortie ($V_{out}$).

4. Dispositif (20) selon l'une quelconque des revendications précédentes, dans lequel le nombre de phases (II, IV, VI) à tension sensiblement constante lors d'un cycle respectif de résonance est supérieur ou égal à 3 ;
   le nombre de phases (II, IV, VI) à tension sensiblement constante lors d'un cycle respectif de résonance étant de préférence égal à 3.

5. Système électronique de conversion d'énergie électrique (5) comprenant :

   - un convertisseur d'énergie électrique (10) apte à convertir une tension d'entrée ($V_{in}$) en au moins une tension de sortie ($V_{out}$), et comportant :

      + un premier pont de commutation (30) comportant deux premières branches de commutation (32), chaque première branche de commutation (32) étant connectée entre deux bornes (34) d'application de la tension d'entrée ($V_{in}$) et comportant au moins deux premiers interrupteurs (36) connectés en série et reliés entre eux en un premier point milieu (38) ;
      + au moins un deuxième pont de commutation (40) comportant deux deuxièmes branches de commutation (42), chaque deuxième branche de commutation (42) étant connectée entre deux bornes (44) de fourniture de la tension de sortie ($V_{out}$) et comportant au moins deux deuxièmes interrupteurs (46) connectés en série et reliés entre eux en un deuxième point milieu (48) ;

+ au moins un couple de premier (12A) et deuxième (12B) ensembles piézoélectriques, chaque ensemble piézoélectrique (12A,12B) comportant au moins un élément piézoélectrique (15) et étant connecté entre des premier (38) et deuxième (48) points milieux respectifs, les points milieux (38, 48) entre lesquels sont connectés les ensembles piézoélectriques (12A,12B) étant distincts d'un ensemble piézoélectrique (12A) à l'autre (12B) ; et

- un dispositif électronique (20) de pilotage du convertisseur d'énergie électrique (10) ;

**caractérisé en ce que** le dispositif de pilotage (20) est selon l'une quelconque des revendications précédentes.

6. Système (5) selon la revendication 5, dans lequel le système électronique de conversion d'énergie électrique (5) est un système de conversion en une énergie électrique continue, tel qu'un système de conversion continu-continu ou un système de conversion alternatif-continu.

7. Système (5) selon la revendication 5 ou 6, dans lequel le convertisseur d'énergie électrique (10) est apte à convertir la tension d'entrée ($V_{in}$) en plusieurs tensions de sortie ($V_{out\_j}$) distinctes, et comporte pour chaque tension de sortie ($V_{out\_j}$) respective :

+ un deuxième pont de commutation (40) respectif, chaque deuxième branche de commutation (42) étant connectée entre deux bornes (44) de fourniture de la tension de sortie ($V_{out\_j}$) respective ;
+ un couple respectif de premier (12A) et deuxième (12B) ensembles piézoélectriques.

8. Système (5) selon l'une quelconque des revendications 5 à 7, dans lequel chaque ensemble piézoélectrique (12A,12B) est constitué selon l'une des constitutions parmi le groupe consistant en : un unique élément piézoélectrique (15) ; plusieurs éléments piézoélectriques (15) connectés en série ; plusieurs éléments piézoélectriques (15) connectés en parallèle ; un élément piézoélectrique (15) et un condensateur auxiliaire connectés en série ; un élément piézoélectrique (15) et un condensateur auxiliaire connectés en parallèle ; et un agencement de plusieurs branches piézoélectriques parallèles, chaque branche comportant un ou plusieurs éléments piézoélectriques (15) connectés en série ou un condensateur auxiliaire ;
le condensateur auxiliaire étant de préférence de capacité supérieure, de préférence encore au moins trois fois supérieure, à une capacité de référence ($C_0$) du ou des éléments piézoélectriques (15), chaque élément piézoélectrique (15) étant modélisé sous forme d'un condensateur (52) et d'une branche résonante (54) connectée en parallèle du condensateur (52), la capacité de référence ($C_0$) étant la capacité dudit condensateur (52).

9. Système (5) selon l'une quelconque des revendications 5 à 8, dans lequel le convertisseur (10) comprend en outre au moins un circuit d'aide à la commutation (50), chaque circuit d'aide à la commutation (50) étant connecté à un point milieu respectif parmi les premier(s) (38) et deuxième(s) (48) points milieux, chaque circuit d'aide à la commutation (50) étant configuré pour, via la circulation d'un courant préalablement reçu, décharger une capacité parasite d'un interrupteur (36 ; 46) du pont de commutation respectif (30 ; 40) auquel il est connecté, et respectivement charger une capacité parasite d'un autre interrupteur (36 ; 46) dudit pont de commutation (30 ; 40).

10. Système (5) selon la revendication 9, dans lequel le convertisseur (10) comprend deux circuits d'aide à la commutation (50), un premier circuit d'aide à la commutation étant connecté au premier pont de commutation (30) et un deuxième circuit d'aide à la commutation étant connecté au deuxième pont de commutation (40).

11. Système (5) selon la revendication 9 ou 10, dans lequel chaque circuit d'aide à la commutation (50) comporte un élément choisi parmi le groupe consistant en : une bobine électromagnétique (70) ; un premier ensemble formé d'une bobine électromagnétique (70) et d'une diode (72) connectées en série ; un deuxième ensemble formé d'une bobine électromagnétique (70) et d'un condensateur (74) connectées en série ; et un élément piézoélectrique additionnel (76) ; chaque circuit d'aide à la commutation (50) étant de préférence constitué d'un élément choisi parmi ledit groupe.

12. Procédé de pilotage d'un convertisseur d'énergie électrique (10) apte à convertir une tension d'entrée ($V_{in}$) en au moins une tension de sortie ($V_{out}$), le convertisseur (10) comportant un premier pont de commutation (30) comportant deux premières branches de commutation (32), chaque première branche de commutation (32) étant connectée entre deux bornes (34) d'application de la tension d'entrée ($V_{in}$) et comportant au moins deux premiers interrupteurs (36) connectés en série et reliés entre eux en un premier point milieu (38) ; au moins un deuxième pont de commutation (40) comportant deux deuxièmes branches de commutation (42), chaque deuxième branche de commutation (42) étant connectée entre deux bornes (44) de fourniture de la tension de sortie ($V_{out}$) et comportant

au moins deux deuxièmes interrupteurs (46) connectés en série et reliés entre eux en un deuxième point milieu (48) ;
au moins un couple de premier (12A) et deuxième (12B) ensembles piézoélectriques, chaque ensemble piézoélectrique (12A,12B) comportant au moins un élément piézoélectrique (15) et étant connecté entre des premier (38) et deuxième (48) points milieux respectifs, les points milieux (38, 48) entre lesquels sont connectés les ensembles piézoélectriques (12A,12B) étant distincts d'un ensemble piézoélectrique (12A) à l'autre (12B) ;

le procédé étant mis en œuvre par un dispositif électronique de pilotage (20) et comprenant la commande, lors d'un cycle respectif de résonance des ensembles piézoélectriques (12A, 12B), d'une commutation de chacun des interrupteurs (36, 46) pour alterner des phases (II, IV, VI) à tension sensiblement constante aux bornes des ensembles piézoélectriques (12A,12B) et des phases (I, III, V) à charge sensiblement constante aux bornes desdits ensembles piézoélectriques (12A,12B) ; par tension sensiblement constante, on entend une variation de tension inférieure à 20% de la tension d'entrée ou de sortie du convertisseur (10) ; et par charge sensiblement constante, on entend un échange d'une charge avec l'extérieur qui est inférieur à 10% de la charge qui aurait été échangée avec l'extérieur si la tension avait été maintenue constante ;

**caractérisé en ce que**, lors de chaque phase (I, III, V) à charge sensiblement constante, au plus un interrupteur respectif parmi les interrupteurs (36A, 46A) connectés directement au premier ensemble piézoélectrique (12A) et au plus un interrupteur respectif parmi les interrupteurs (36B, 46B) connectés directement au deuxième ensemble piézoélectrique (12B) sont commandés en position fermée en même temps, et tous les autres interrupteurs (36, 46) des premières et deuxièmes branches de commutation (32, 42) sont commandés en position ouverte.

## Patentansprüche

1. Elektronische Vorrichtung (20) zur Steuerung eines Stromwandlers (10), der imstande ist, eine Eingangsspannung ($V_{in}$) in mindestens eine Ausgangsspannung ($V_{out}$) umzuwandeln, wobei der Wandler (10) eine erste Schaltbrücke (30) aufweist, die zwei erste Schaltzweigen (32) aufweist, wobei jeder erste Schaltzweig (32) zwischen zwei Klemmen (34) zum Anlegen der Eingangsspannung ($V_{in}$) angeschlossen ist und mindestens zwei erste Schalter (36) aufweist, die in Reihe geschaltet und in einem ersten Mittelpunkt (38) miteinander verbunden sind; mindestens eine zweite Schaltbrücke (40), die zwei zweite Schaltzweige (42) aufweist, wobei jeder zweite Schaltzweig (42) zwischen zwei Klemmen (44) zur Bereitstellung der Ausgangsspannung ($V_{out}$) angeschlossen ist und mindestens zwei zweite Schalter (46) aufweist, die in Reihe geschaltet und in einem zweiten Mittelpunkt (48) miteinander verbunden sind; mindestens ein Paar aus erster (12A) und zweiter (12B) piezoelektrischer Anordnung, wobei jede piezoelektrische Anordnung (12A, 12B) mindestens ein piezoelektrisches Element (15) aufweist und zwischen dem jeweiligen ersten (38) und zweiten (48) Mittelpunkt angeschlossen ist, wobei die Mittelpunkte (38, 48), zwischen denen die piezoelektrischen Anordnungen (12A, 12B) angeschlossen sind, von einer piezoelektrischen Anordnung (12A) zur anderen (12B) verschieden sind;

wobei die Steuerelektronik (20) ausgelegt ist, um während eines jeweiligen Resonanzzyklus der piezoelektrischen Anordnungen (12A, 12B) ein Schalten von jedem der Schalter (36, 46) zu befehlen, um Phasen (II, IV, VI) mit im Wesentlichen konstanter Spannung an den Klemmen der piezoelektrischen Anordnungen (12A, 12B) und Phasen (I, III, V) mit im Wesentlichen konstanter Last an den Klemmen der piezoelektrischen Anordnungen (12A, 12B) abzuwechseln; wobei unter einer im Wesentlichen konstanten Spannung eine Spannungsänderung von weniger als 20 % der Eingangs- oder Ausgangsspannung des Wandlers (10) zu verstehen ist; und wobei unter einer im Wesentlichen konstanten Last ein Austausch einer Last mit außerhalb zu verstehen ist, der weniger als 10 % der Last beträgt, die mit außerhalb ausgetauscht worden wäre, wenn die Spannung konstant gehalten worden wäre;

**dadurch gekennzeichnet, dass** die elektronische Steuervorrichtung (20) ausgelegt ist, um während jeder Phase (I, III, V) mit im Wesentlichen konstanter Last gleichzeitig höchstens einen jeweiligen Schalter der Schalter (36A, 46A), die direkt mit der ersten piezoelektrischen Anordnung (12A) verbunden sind, und höchstens einen jeweiligen Schalter der Schalter (36B, 46B), die direkt mit der zweiten piezoelektrischen Anordnung (12B) verbunden sind, in die geschlossene Position, und alle anderen Schalter (36, 46) der ersten und zweiten Schaltzweige (32, 42) in die offene Position zu schalten.

2. Vorrichtung (20) nach Anspruch 1, wobei der Wert ($V_a$, $V_b$, $V_c$) der Spannung jeder der Phasen (II, IV, VI) mit im Wesentlichen konstanter Spannung von dem Wert Null verschieden ist.

3. Vorrichtung (20) nach Anspruch 2, wobei der Wert ($V_a$, $V_b$, $V_c$) der Spannung jeder der Phasen (II, IV, VI) mit im Wesentlichen konstanter Spannung aus der Gruppe ausgewählt ist, die besteht aus: Differenz ($V_{in}$ - $V_{out}$) zwischen dem Wert der Eingangsspannung ($V_{in}$) und dem Wert der Ausgangsspannung ($V_{out}$); Differenz ($V_{out}$ -$V_{in}$) zwischen dem Wert der Ausgangsspannung ($V_{out}$) und dem Wert der Eingangsspannung ($V_{in}$); Summe ($V_{in}$ + $V_{out}$) der Werte der Eingangsspannung ($V_{in}$) und der Ausgangsspannung ($V_{out}$); und Gegenteil der Summe (-$V_{in}$ -$V_{out}$) der Werte der Eingangsspannung ($V_{in}$) und der Ausgangsspannung ($V_{out}$).

**4.** Vorrichtung (20) nach einem der vorhergehenden Ansprüche, wobei die Anzahl der Phasen (II, IV, VI) mit im Wesentlichen konstanter Spannung während eines jeweiligen Resonanzzyklus größer oder gleich 3 ist; wobei die Anzahl der Phasen (II, IV, VI) mit im Wesentlichen konstanter Spannung während eines jeweiligen Resonanzzyklus vorzugsweise gleich 3 ist.

**5.** Elektronisches Stromwandlersystem (5), umfassend:

- einen Stromwandler (10), der geeignet ist, eine Eingangsspannung ($V_{in}$) in mindestens eine Ausgangsspannung ($V_{out}$) umzuwandeln, und der aufweist:

+ eine erste Schaltbrücke (30) mit zwei ersten Schaltzweigen (32), wobei jeder erste Schaltzweig (32) zwischen zwei Klemmen (34) zum Anlegen der Eingangsspannung ($V_{in}$) angeschlossen ist und mindestens zwei erste Schalter (36) aufweist, die in Reihe geschaltet und in einem ersten Mittelpunkt (38) miteinander verbunden sind;
+ mindestens eine zweite Schaltbrücke (40) mit zwei zweiten Schaltzweigen (42), wobei jeder zweite Schaltzweig (42) zwischen zwei Klemmen (44) zur Bereitstellung der Ausgangsspannung ($V_{out}$) angeschlossen ist und mindestens zwei zweite Schalter (46) aufweist, die in Reihe geschaltet und in einem zweiten Mittelpunkt (48) miteinander verbunden sind;
+ mindestens ein Paar aus erster (12A) und zweiter (12B) piezoelektrischer Anordnung, wobei jede piezoelektrische Anordnung (12A, 12B) mindestens ein piezoelektrisches Element (15) umfasst und zwischen einem jeweiligen ersten (38) und zweiten (48) Mittelpunkt angeschlossen ist, wobei die Mittelpunkte (38, 48), zwischen denen die piezoelektrischen Anordnungen (12A, 12B) angeschlossen sind, von einer piezoelektrischen Anordnung (12A) zur anderen (12B) verschieden sind; und

- eine elektronische Vorrichtung (20) zur Steuerung des Stromwandlers (10);

**dadurch gekennzeichnet, dass** die elektronische Steuervorrichtung (20) nach einem der vorherigen Ansprüche ist.

**6.** System (5) nach Anspruch 5, wobei das elektronische Stromwandlersystem (5) ein System zur Umwandlung in einen Gleichstrom wie etwa ein Gleichstrom-Gleichstrom-Wandlersystem oder ein Wechselstrom-Gleichstrom-Wandlersystem ist.

**7.** System (5) nach Anspruch 5 oder 6, wobei der Stromwandler (10) geeignet ist, die Eingangsspannung ($V_{in}$) in mehrere verschiedene Ausgangsspannungen ($V_{out\_j}$) umzuwandeln, und aufweist für jede jeweilige Ausgangsspannung ($V_{out\_j}$)

+ eine jeweilige zweite Schaltbrücke (40), wobei jeder zweite Schaltzweig (42) zwischen zwei Klemmen (44) zur Bereitstellung der jeweiligen Ausgangsspannung ($V_{out\_j}$) angeschlossen ist;
+ ein jeweiliges Paar aus erster (12A) und zweiter (12B) piezoelektrischer Anordnung.

**8.** System (5) nach einem der Ansprüche 5 bis 7, wobei jede piezoelektrische Anordnung (12A, 12B) gemäß einer der Ausgestaltungen aus der Gruppe ausgebildet ist, die besteht aus: einem einzigen piezoelektrischen Element (15); mehreren in Reihe geschalteten piezoelektrischen Elementen (15); mehreren parallel geschalteten piezoelektrischen Elementen (15); einem piezoelektrischen Element (15) und einem in Reihe geschalteten Hilfskondensator; einem piezoelektrischen Element (15) und einem parallel geschalteten Hilfskondensator; und einer Anordnung aus mehreren parallelen piezoelektrischen Zweigen, wobei jeder Zweig ein oder mehrere in Reihe geschaltete piezoelektrische Elemente (15) oder einen Hilfskondensator aufweist; wobei der Hilfskondensator vorzugsweise eine größere Kapazität, vorzugsweise noch mindestens dreimal größer, als eine Referenzkapazität ($C_0$) des oder der piezoelektrischen Elemente (15) aufweist, wobei jedes piezoelektrische Element (15) in Form eines Kondensators (52) und eines parallel zum Kondensator (52) geschalteten Resonanzzweigs (54) modelliert wird, wobei die Referenzkapazität ($C_0$) die Kapazität des Kondensators (52) ist.

9. System (5) nach einem der Ansprüche 5 bis 8, wobei der Wandler (10) ferner mindestens eine Schaltunterstützungsschaltung (50) umfasst, wobei jede Schaltunterstützungsschaltung (50) mit einem jeweiligen des/der ersten (38) und des/der zweiten (48) Mittelpunkte/s verbunden ist, wobei jede Schaltunterstützungsschaltung (50) ausgelegt ist, um über den Fluss eines zuvor empfangenen Stroms eine Streukapazität eines Schalters (36; 46) der jeweiligen Schaltbrücke (30; 40), mit der er verbunden ist, zu entladen und jeweils eine Streukapazität eines anderen Schalters (36; 46) der Schaltbrücke (30; 40) zu laden.

10. System (5) nach Anspruch 9, wobei der Wandler (10) zwei Schaltunterstützungsschaltungen (50) umfasst, wobei eine erste Schaltunterstützungsschaltung mit der ersten Schaltbrücke (30) verbunden ist und eine zweite Schaltunterstützungsschaltung mit der zweiten Schaltbrücke (40) verbunden ist.

11. System (5) nach Anspruch 9 oder 10, wobei jede Schaltunterstützungsschaltung (50) ein Element aufweist, das aus der Gruppe ausgewählt ist, die besteht aus: einer elektromagnetischen Spule (70); einer ersten Anordnung aus einer elektromagnetischen Spule (70) und einer Diode (72), die in Reihe geschaltet sind; einer zweiten Anordnung aus einer elektromagnetischen Spule (70) und einem Kondensator (74), die in Reihe geschaltet sind; und einem zusätzlichen piezoelektrischen Element (76);
wobei jede Schaltunterstützungsschaltung (50) vorzugsweise aus einem Element besteht, das aus der Gruppe ausgewählt ist.

12. Verfahren zur Steuerung eines Stromwandlers (10), der imstande ist, eine Eingangsspannung ($V_{in}$) in mindestens eine Ausgangsspannung ($V_{out}$) umzuwandeln, wobei der Wandler (10) eine erste Schaltbrücke (30) aufweist, die zwei erste Schaltzweige (32) aufweist, wobei jeder erste Schaltzweig (32) zwischen zwei Klemmen (34) zum Anlegen der Eingangsspannung ($V_{in}$) angeschlossen ist und mindestens zwei erste Schalter (36) aufweist, die in Reihe geschaltet und in einem ersten Mittelpunkt (38) miteinander verbunden sind; mindestens eine zweite Schaltbrücke (40), die zwei zweite Schaltzweige (42) aufweist, wobei jeder zweite Schaltzweig (42) zwischen zwei Klemmen (44) zur Bereit-stellung der Ausgangsspannung ($V_{out}$) angeschlossen ist und mindestens zwei zweite Schalter (46) aufweist, die in Reihe geschaltet und in einem zweiten Mittelpunkt (48) miteinander verbunden sind; mindestens ein Paar aus erster (12A) und zweiter (12B) piezoelektrischer Anordnung, wobei jede piezoelektrische Anordnung (12A, 12B) mindestens ein piezoelektrisches Element (15) aufweist und zwischen dem jeweiligen ersten (38) und zweiten (48) Mittelpunkt verbunden ist, wobei die Mittelpunkte (38, 48), zwischen denen die piezoelektrischen Anordnungen (12A, 12B) verbunden sind, von einer piezoelektrischen Anordnung (12A) zur anderen (12B) verschieden sind;

wobei das Verfahren von einer elektronischen Steuervorrichtung (20) durchgeführt wird und während eines jeweiligen Resonanzzyklus der piezoelektrischen Anordnungen (12A, 12B) den Befehl eines Schaltens jedes der Schalter (36, 46) umfasst, um Phasen (II, IV, VI) mit im Wesentlichen konstanter Spannung an den Klemmen der piezoelektrischen Anordnungen (12A, 12B) und Phasen (I, III, V) mit im Wesentlichen konstanter Last an den piezoelektrischen Anordnungen (12A, 12B) abzuwechseln; wobei unter einer im Wesentlichen konstanten Spannung eine Spannungsänderung von weniger als 20 % der Eingangs- oder Ausgangsspannung des Wandlers (10) zu verstehen ist; und wobei unter einer im Wesentlichen konstanten Last ein Austausch einer Last mit außerhalb zu verstehen ist, der weniger als 10 % der Last beträgt, die mit außerhalb ausgetauscht worden wäre, wenn die Spannung konstant gehalten worden wäre;
**dadurch gekennzeichnet, dass** während jeder Phase (I, III, V) mit im Wesentlichen konstanter Last gleichzeitig höchstens ein jeweiliger Schalter der Schalter (36A, 46A), die direkt mit der ersten piezoelektrischen Anordnung (12A) verbunden sind, und höchstens ein jeweiliger Schalter der Schalter (36B, 46B), die direkt mit der zweiten piezoelektrischen Anordnung (12B) verbunden sind, gleichzeitig in die geschlossene Position geschaltet werden, und alle anderen Schalter (36, 46) der ersten und zweiten Schaltzweige (32, 42) in die offene Position geschaltet werden.

**Claims**

1. An electronic control device (20) for controlling an electrical energy converter (10) capable of converting an input voltage ($V_{in}$) into at least one output voltage ($V_{out}$), the converter (10) comprising a first switching bridge (30) comprising two first switching branches (32), each first switching branch (32) being connected between two terminals (34) for applying the input voltage ($V_{in}$) and comprising at least two first switches (36) connected in series and linked together at a first midpoint (38); at least one second switching bridge (40) comprising two second switching branches (42), each second switching branch (42) being connected between two terminals (44) for supplying the output voltage ($V_{out}$) and comprising at least two second switches (46) connected in series and linked together at a second midpoint (48); at least a pair of first (12A) and second (12B) piezoelectric assemblies, each piezoelectric assembly (12A, 12B) comprising at least one piezoelectric element (15) and being connected between respective first (38) and second (48) midpoints, the midpoints (38, 48) between which the piezoelectric assemblies (12A, 12B) are connected being distinct from one piezoelectric assembly (12A) to the other (12B);

the electronic control device (20) is configured to command, during a respective resonance cycle of the piezoelectric assemblies (12A, 12B), a switching of each of the switches (36, 46) to alternate phases (II, IV, VI) at substantially constant voltage across the piezoelectric assemblies (12A,12B) and phases (I, III, V) at substantially constant load across said piezoelectric assemblies (12A,12B); substantially constant voltage means a voltage variation of less than 20% of the input or output voltage of the converter (10); and substantially constant load means an exchange of a load with the outside which is less than 10% of the load which would have been exchanged with the outside if the voltage had been kept constant;

**characterized in that** the electronic control device (20) is configured so as, during each phase (I, III, V) at substantially constant load, to command into the closed position at the same time at most one respective one of the switches (36A, 46A) connected directly to the first piezoelectric assembly (12A) and at most one respective one of the switches (36B, 46B) connected directly to the second piezoelectric assembly (12B), and to command into the open position all the other switches (36, 46) of the first and second switching branches (32, 42).

2.   The device (20) according to claim 1, wherein the value ($V_a$, $V_b$, $V_c$) of the voltage of each of the phases (II, IV, VI) at substantially constant voltage is distinct from zero.

3.   The device (20) according to claim 2, wherein the value ($V_a$, $V_b$, $V_c$) of the voltage of each of the phases (II, IV, VI) at substantially constant voltage is selected from the group consisting of: difference ($V_{in}$ - $V_{out}$) between the value of the input voltage ($V_{in}$) and that of the output voltage ($V_{out}$); difference ($V_{out}$ - $V_{in}$) between the value of the output voltage ($V_{out}$) and that of the input voltage ($V_{in}$); sum ($V_{in}$ + $V_{out}$) of the values of the input ($V_{in}$) and output ($V_{out}$) voltages; and opposite of the sum (-$V_{in}$ -$V_{out}$) of the values of the input ($V_{in}$) and output ($V_{out}$) voltages.

4.   The device (20) according to any of the preceding claims, wherein the number of phases (II, IV, VI) at substantially constant voltage during a respective resonance cycle is greater than or equal to 3; the number of phases (II, IV, VI) at substantially constant voltage during a respective resonance cycle preferably being equal to 3.

5.   An electronic power conversion system (5) comprising:

- an electrical energy converter (10) capable of converting an input voltage ($V_{in}$) into at least one output voltage ($V_{out}$), and comprising:

+ a first switching bridge (30) comprising two first switching branches (32), each first switching branch (32) being connected between two terminals (34) for applying the input voltage ($V_{in}$) and comprising at least two first switches (36) connected in series and linked together at a first midpoint (38);
+ at least one second switching bridge (40) with two second switching branches (42), each second switching branch (42) being connected between two terminals (44) for supplying the output voltage ($V_{out}$) and comprising at least two second switches (46) connected in series and linked together at a second midpoint (48);
+ at least one pair of first (12A) and second (12B) piezoelectric assemblies, each piezoelectric assembly (12A,12B) having at least one piezoelectric element (15) and being connected between respective first (38) and second (48) midpoints, the midpoints (38, 48) between which the piezoelectric assemblies (12A, 12B) are connected being distinct from one piezoelectric assembly (12A) to the other (12B); and

- an electronic control device (20) for controlling the electrical energy converter (10);

**characterized in that** the control device (20) is according to any of the preceding claims.

6.   The system (5) according to claim 5, wherein the electronic system for electrical energy conversion (5) is a DC electrical energy conversion system, such as a DC-DC conversion system or an AC-DC conversion system.

7.   The system (5) according to claim 5 or 6, wherein the electrical energy converter (10) is capable of converting the input voltage ($V_{in}$) into a plurality of distinct output voltages ($V_{out\_j}$), and comprises

for each respective output voltage ($V_{out\_j}$):

+ a respective second switching bridge (40), each second switching branch (42) being connected between two respective output voltage ($V_{out\_j}$) supply terminals (44);
+ a respective pair of first (12A) and second (12B) piezoelectric assemblies.

8. The system (5) according to any of claims 5 to 7, wherein each piezoelectric assembly (12A, 12B) consists of one of the group consisting of: a single piezoelectric element (15); a plurality of piezoelectric elements (15) connected in series; a plurality of piezoelectric elements (15) connected in parallel; a piezoelectric element (15) and an auxiliary capacitor connected in series; a piezoelectric element (15) and an auxiliary capacitor connected in parallel; and an arrangement of a plurality of parallel piezoelectric branches, each branch comprising one or more piezoelectric elements (15) connected in series or an auxiliary capacitor;
the auxiliary capacitor preferably having a capacitance greater than, preferably at least three times greater than, a reference capacitance ($C_0$) of the piezoelectric element(s) (15), each piezoelectric element (15) being modelled as a capacitor (52) and a resonant branch (54) connected in parallel to the capacitor (52), the reference capacitance ($C_0$) being the capacitance of said capacitor (52).

9. The system (5) according to any of claims 5 to 8, wherein the converter (10) further comprises at least one switching aid circuit (50), each switching aid circuit (50) being connected to a respective one of the first (38) and second (48) midpoints, each switching aid circuit (50) being configured to, via the flow of a previously received current, discharge a parasitic capacitance of a switch (36, 46) of the respective switching bridge (30, 40) to which it is connected, and respectively charge a parasitic capacitance of another switch (36, 46) of said switching bridge (30, 40).

10. The system (5) according to claim 9, wherein the converter (10) comprises two switching aid circuits (50), a first switching aid circuit being connected to the first switching bridge (30) and a second switching aid circuit being connected to the second switching bridge (40).

11. The system (5) according to claim 9 or 10, wherein each switching aid circuit (50) comprises an element selected from the group consisting of: an electromagnetic coil (70); a first set of an electromagnetic coil (70) and a diode (72) connected in series; a second set of an electromagnetic coil (70) and a capacitor (74) connected in series; and an additional piezoelectric element (76);
each switching aid circuit (50) preferably consisting of an element selected from said group.

12. A method for controlling an electrical energy converter (10) capable of converting an input voltage ($V_{in}$) into at least one output voltage ($V_{out}$), the converter (10) comprising a first switching bridge (30) comprising two first switching branches (32), each first switching branch (32) being connected between two terminals (34) for applying the input voltage ($V_{in}$) and comprising at least two first switches (36) connected in series and linked together at a first midpoint (38); at least one second switching bridge (40) comprising two second switching branches (42), each second switching branch (42) being connected between two terminals (44) for supplying the output voltage ($V_{out}$) and comprising at least two second switches (46) connected in series and linked together at a second midpoint (48); at least a pair of first (12A) and second (12B) piezoelectric assemblies, each piezoelectric assembly (12A, 12B) comprising at least one piezoelectric element (15) and being connected between respective first (38) and second (48) midpoints, the midpoints (38, 48) between which the piezoelectric assemblies (12A, 12B) are connected being distinct from one piezoelectric assembly (12A) to the other (12B);

the method being implemented by an electronic control device (20) and comprising the commanding, during a respective resonance cycle of the piezoelectric assemblies (12A, 12B), of a switching of each of the switches (36, 46) to alternate phases (II, IV, VI) at substantially constant voltage across the piezoelectric assemblies (12A,12B) and phases (I, III, V) at substantially constant load across said piezoelectric assemblies (12A,12B); substantially constant voltage means a voltage variation of less than 20% of the input or output voltage of the converter (10); and substantially constant load means an exchange of a load with the outside which is less than 10% of the load which would have been exchanged with the outside if the voltage had been kept constant;
**characterized in that**, during each phase (I, III, V) at substantially constant load, at most one respective switch among the switches (36A, 46A) directly connected to the first piezoelectric assembly (12A) and at most one respective switch among the switches (36B, 46B) directly connected to the second piezoelectric assembly (12B) are in the closed position at the same time, with all the other switches (36, 46) of the first and second switching branches (32, 42) being commanded in the open position.

FIG.1

FIG.2

FIG.3

FIG.4

**FIG.5**

FIG.6

FIG.7

FIG.8

EP 4 191 854 B1

FIG.9

## RÉFÉRENCES CITÉES DANS LA DESCRIPTION

**Documents brevets cités dans la description**

- FR 3086471 A1
- FR 3086472 A1
- US 2013169198 A1
- FR 2107345